(19) Europäisches Patentamt
European Patent Office
Office européen des brevets

(11) EP 3 981 806 A1

(12) EUROPEAN PATENT APPLICATION

(43) Date of publication:
13.04.2022 Bulletin 2022/15

(21) Application number: 21201223.1

(22) Date of filing: 06.10.2021

(51) International Patent Classification (IPC):
*C08F 226/06* (2006.01) *C08K 5/00* (2006.01)
*G03F 7/004* (2006.01) *C08L 39/04* (2006.01)
*G02B 5/00* (2006.01) *G02F 1/00* (2006.01)
*G03F 7/033* (2006.01)

(52) Cooperative Patent Classification (CPC):
(C-Sets available)
**G03F 7/038; C08F 226/06; C08K 5/0025; G03F 7/0388;** G02B 5/20 (Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.10.2020 US 202063089820 P**

(71) Applicants:
- **Rohm and Haas Electronic Materials LLC**
  **Marlborough, MA 01752 (US)**
- **DuPont Electronics, Inc.**
  **Wilmington, DE 19805 (US)**
- **Rohm And Haas Electronic Materials Korea Ltd.**
  **Chungcheongnam-do 331-980 (KR)**

(72) Inventors:
- **PATTERSON, Anastasia**
  **Marlborough, 01752 (US)**
- **WANG, Deyan**
  **Marlborough, 01752 (US)**
- **SECKMAN, Bethany L.**
  **Marlborough, 01752 (US)**
- **GILMORE, Christopher D.**
  **Marlborough, 01752 (US)**
- **YOON, Hee Jae**
  **31093 Cheonan-si (KR)**
- **CHAVEZ, Anton D.**
  **Marlborough, 01752 (US)**
- **MULZER, Catherine**
  **Marlborough, 01752 (US)**
- **HOWARD JR., Michael Henry**
  **19803 Wilmington (DE)**
- **METH, Jeffrey Scott**
  **19803 Wilmington (DE)**
- **JUNG, Ju-Young**
  **18449 Hwaseong-si (KR)**
- **LEE, Eun-Young**
  **18449 Hwaseong-si (KR)**

(74) Representative: **Houghton, Mark Phillip**
**Patent Outsourcing Limited**
**Corner House**
**1 King Street**
**Bakewell**
**Derbyshire DE45 1DZ (GB)**

# (54) HIGH REFRACTIVE INDEX MATERIALS

(57) Disclosed is a formulation comprising a copolymer comprising one or more high refractive index first monomers and one or more second monomers comprising a reactive side chain and one or more solvents. The formulation may optionally contain additional components. Further disclosed are methods for forming optical thin films from the formulation and optical devices containing the optical thin films.

EP 3 981 806 A1

(52) Cooperative Patent Classification (CPC): (Cont.)

C-Sets
**C08F 226/06, C08F 212/24;**
**C08F 226/06, C08F 220/06;**
**C08F 226/06, C08F 220/1804;**
**C08F 226/06, C08F 220/20;**
**C08F 226/06, C08F 220/283;**
**C08K 5/0025, C08L 39/04;**
**G02B 1/041, C08L 39/00**

## Description

BACKGROUND OF THE INVENTION

Field of the Disclosed and Claimed Inventive Concepts

The presently disclosed process(es), procedure(s), method(s), product(s), result(s), and/or concept(s) (collectively referred to hereinafter as the "present disclosure") relate generally to copolymer compositions, formulations, and methods to prepare optical thin films and materials therefrom. In particular, the films are found to exhibit optical and other properties that make them useful in a variety of optical and electronics applications.

Background and Applicable Aspects of the Presently Disclosed and Claimed Inventive Concept(s)

Materials for use in electronics and displays applications often have strict requirements in terms of their structural, optical, thermal, electronic, and other properties. As the number of commercial electronics and displays applications continues to grow, the breadth and specificity of requisite properties demand the innovation of materials with new and/or improved properties. Polymeric materials are increasingly finding use in such applications as a result of their widely-variable properties and processability advantages over more-conventional incumbent materials.

Polymers can often be made to exhibit an effective combination of good chemical resistance, high $T_g$, and mechanical toughness that are required in many electronics and displays applications. Further, their molecular weight and solution concentration may be adjusted to enable precise and convenient deposition by spin-coating - a universally-important industrial processing method. Also, the synthetic flexibility that is afforded by heteroatom inclusion, copolymer formation, and the like makes available families of materials that can be prepared for highly-specific applications in-use.

Polymeric materials can often exhibit optical properties that make them particularly well-suited to address the technical challenges provided by optical elements and devices of increasing utility and complexity. Many such devices can exhibit significant losses in efficiency because of the way that light moves within and through their structural elements. Display devices like LEDs and OLEDs often suffer significantly-reduced efficiencies because light generated is lost via scattering and internal reflection. As generated light passes between elements or layers of different refractive indices, a significant percentage of it can be lost. Further, cross-talk between pixels in OLEDS can lead to efficiency losses that result from unwanted communication between red, green, and blue pixels. These display-device inefficiencies are all possibly addressable through more-precise management of the refractive indices, and the relative refractive indices, of their respective components. The introduction of a relatively-high-refractive index light-extraction layer between an OLED encapsulant layer and polarizer layer, for example, can greatly increase the number of photons emitted from a top-display device. Further, the use of relatively low-refractive-index banks between pixels in the emissive layer of an OLED can significantly reduce cross-talk to generate improved efficiencies.

Similar considerations can apply to optical devices wherein the light in question is incident-versus-emitted. CMOS image sensors (CIS) can suffer reduced efficiencies that result from scattering by a refractive-index mismatch between the external environment and the color filter surface. This can be matched via the introduction of a high-surface-area microlens on top of the color filter, and the scattered light can be recovered for detection. Further, and similar to the case for OLEDs, low-refractive-index spacers can be used between the red, green, and blue color filters to minimize pixel cross-talk in CMOS image sensors.

Indeed, CMOS image sensors are being integrated into more applications, demanding greater versatility be incorporated into their design. To enable smaller CIS to achieve identical performance as their larger forebears, higher pixel density is demanded. Likewise, expanded-use cases include sensitivity into the near-IR (light wavelengths 800-1000nm). CIS designs include variable components, but the essential function is the same for each pixel. As light enters the sensor, it travels through (1) a transparent shaped lensing element; (2) a wavelength-specific (RGB) color filter; and (3) a doped metallic Si optoelectronic element, generating an electrical signal that triggers a signal in the CMOS integrated circuit (IC). Greater pixel density requires miniaturization of all of these components, but RGB color filters and doped Si are predominantly 2D features, and therefore adapt high-resolution lithography processes to aid miniaturization. The lensing element ("microlens") is shaped in 3 dimensions, typically in hemispherical motifs. In fabrication, the ability to form hemispheres is primarily driven by material surface tension, but smaller pixels limit the curvature of microlenses made in this fashion. Lens focal length in these situations can be maintained at a lesser curvature by increasing the refractive index of the material from which it is constructed.

Judicious use of optical materials in other types of devices can similarly be used to drive efficiency improvements, although sometimes materials' refractive indices are manipulated to increase internal reflection. Core/clad waveguides, for example, operate most efficiently when transmitted light passes longitudinally through the guide. In practice, however, a portion of the transmitted light travels off-axis and escapes the guide. This situation can be remedied via the use of materials for the core (low refractive index) and cladding (high refractive index) that maximize the refractive index

difference between the concentric layers to drive internal reflection and thereby reduce signal loss.

These, and other, optical uses continue to place ever-more-stringent optical requirements on device materials. The materials disclosed herein offer the potential to meet such demands, and they can find advantages-in-use not only because of their inherent processability, but also because specific optical properties can be tuned to meet the exacting parametric demands of increasingly-complicated optical devices. Because of this, there is an ongoing need for the development of such materials in this context. Not only will the current-device performance / efficiency be improved, but components with superior light management capabilities will facilitate the drive towards new devices with smaller optical elements for use in an expanding number of commercial applications.

## DETAILED DESCRIPTION

Before explaining at least one embodiment of the present disclosure in detail, it is to be understood that the present disclosure is not limited in its application to the details of construction and the arrangement of the components or steps or methodologies set forth in the following description. The present disclosure is capable of other embodiments or of being practiced or carried out in various ways. Also, it is to be understood that the phraseology and terminology employed herein is for the purpose of description and should not be regarded as limiting.

Unless otherwise defined herein, technical terms used in connection with the present disclosure shall have the meanings that are commonly understood by those of ordinary skill in the art. Further, unless otherwise required by context, singular terms shall include pluralities and plural terms shall include the singular.

All patents, published patent applications, and non-patent publications mentioned in the specification are indicative of the level of skill of those skilled in the art to which the present disclosure pertains. All patents, published patent applications, and non-patent publications referenced in any portion of this application are herein expressly incorporated by reference in their entirety to the same extent as if each individual patent or publication was specifically and individually indicated to be incorporated by reference.

All of the articles and/or methods disclosed herein can be made and executed without undue experimentation in light of the present disclosure. While the articles and methods of the present disclosure have been described in terms of preferred embodiments, it will be apparent to those of ordinary skill in the art that variations may be applied to the articles and/or methods and in the steps or in the sequence of steps of the method(s) described herein without departing from the concept, spirit and scope of the present disclosure. All such similar substitutes and modifications apparent to those skilled in the art are deemed to be within the spirit, scope and concept of the present disclosure.

As utilized in accordance with the present disclosure, the following terms, unless otherwise indicated, shall be understood to have the following meanings.

The use of the word "a" or "an" when used in conjunction with the term "comprising" may mean "one," but it is also consistent with the meaning of "one or more," "at least one," and "one or more than one." The use of the term "or" is used to mean "and/or" unless explicitly indicated to refer to alternatives only if the alternatives are mutually exclusive, although the disclosure supports a definition that refers to only alternatives and "and/or." Throughout this application, the term "about" is used to indicate that a value includes the inherent variation of error for the quantifying device, the method(s) being employed to determine the value, or the variation that exists among the study subjects. For example, but not by way of limitation, when the term "about" is utilized, the designated value may vary by plus or minus twelve percent, or eleven percent, or ten percent, or nine percent, or eight percent, or seven percent, or six percent, or five percent, or four percent, or three percent, or two percent, or one percent. The use of the term " at least one" will be understood to include one as well as any quantity more than one, including but not limited to, 1, 2, 3, 4, 5, 10, 15, 20, 30, 40, 50, 100, etc. The term "at least one" may extend up to 100 or 1000 or more depending on the term to which it is attached. In addition, the quantities of 100/1000 are not to be considered limiting as lower or higher limits may also produce satisfactory results. In addition, the use of the term "at least one of X, Y, and Z" will be understood to include X alone, Y alone, and Z alone, as well as any combination of X, Y, and/or Z. The use of ordinal number terminology (i.e., "first", "second", "third", "fourth", etc.) is solely for the purpose of differentiating between two or more items and, unless otherwise stated, is not meant to imply any sequence or order or importance to one item over another or any order of addition.

As used herein, the words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps. The terms "or combinations thereof' and "and/or combinations thereof' as used herein refer to all permutations and combinations of the listed items preceding the term. For example, "A, B, C, or combinations thereof' is intended to include at least one of: A, B, C, AB, AC, BC, or ABC and, if order is important in a particular context, also BA, CA, CB, CBA, BCA, ACB, BAC, or CAB. Continuing with this example, expressly included are combinations that contain repeats of one or more items or terms, such as BB, AAA, AAB, BBC, AAABCCCC, CBBAAA, CABABB, and so forth. The skilled artisan will understand that typically there is no limit on the

number of items or terms in any combination, unless otherwise apparent from the context.

As used herein, the term "substantially" means that the subsequently described circumstance completely occurs or that the subsequently described circumstance occurs to a great extent or degree.

For purposes of the following detailed description, other than in any operating examples, or where otherwise indicated, numbers that express, for example, quantities of ingredients used in the specification and claims are to be understood as being modified in all instances by the term "about." The numerical parameters set forth in the specification and attached claims are approximations that may vary depending upon the desired properties to be obtained in carrying out the invention.

The term "alicyclic" refers to a cyclic group that is not aromatic. The group can be saturated or unsaturated, but it does not exhibit aromatic character.

The term "alkyl" refers to a saturated linear or branched hydrocarbon group of 1 to 50 carbons. It further includes both substituted and unsubstituted hydrocarbon groups. The term is further intended to include heteroalkyl groups.

The term "aprotic" refers to a class of solvents that lack an acidic hydrogen atom and are therefore incapable of acting as hydrogen donors. Common aprotic solvents include alkanes, carbon tetrachloride ($CCl_4$), benzene, dimethyl formamide (DMF), N-methyl-2-pyrrolidone (NMP), dimethylacetamide (DMAc), propylene glycol methyl ether acetate (PGMEA), anisole, cyclohexanone, benzyl benzoate, cyclopentanone, methyl ethyl ketone and many others.

The term "aromatic compound" refers to an organic compound comprising at least one unsaturated cyclic group having $4n+\mu$delocalized pi electrons. The term is intended to encompass both aromatic compounds having only carbon and hydrogen atoms, and heteroaromatic compounds wherein one or more of the carbon atoms within the cyclic group has been replaced by another atom, such as nitrogen, oxygen, sulfur, or the like.

The term "aryl" or "aryl group" refers to a moiety formed by removal of one or more hydrogen ("H") or deuterium ("D") from an aromatic compound. The aryl group may be a single ring (monocyclic) or have multiple rings (bicyclic, or more) fused together or linked covalently. A "carbocyclic aryl" has only carbon atoms in the aromatic ring(s). A "heteroaryl" has one or more heteroatoms in at least one aromatic ring.

The term "alkoxy" refers to the group -OR, where R is alkyl.

The term "aryloxy" refers to the group -OR, where R is aryl.

Unless otherwise indicated, all groups can be substituted or unsubstituted. An optionally substituted group, such as, but not limited to, alkyl or aryl, may be substituted with one or more substituents which may be the same or different. Suitable substituents include alkyl, aryl, nitro, cyano, -N(R')(R"), halo, hydroxy, carboxy, alkenyl, alkynyl, cycloalkyl, heteroaryl, alkoxy, aryloxy, heteroaryloxy, alkoxycarbonyl, perfluoroalkyl, perfluoroalkoxy, arylalkyl, silyl, siloxy, siloxane, thioalkoxy, $-S(O)_2-$, -C(=O)-N(R')(R"), (R')(R")N-alkyl, (R')(R")N-alkoxyalkyl, (R')(R")N-alkylaryloxyalkyl, $-S(O)_s$-aryl (where s=0-2) or $-S(O)_s$-heteroaryl (where s=0-2). Each R' and R" is independently an optionally substituted alkyl, cycloalkyl, or aryl group. R' and R", together with the nitrogen atom to which they are bound, can form a ring system in certain embodiments. Substituents may also be crosslinking groups.

The term "amine" refers to a compound that contains a basic nitrogen atom with a lone pair. The term "amino" refers to the functional group $—NH_2$, —NHR, or $—NR_2$, where R is the same or different at each occurrence and can be an alkyl group or an aryl group. The term "diamine" refers to a compound that contains two basic nitrogen atoms with associated lone pairs. The term "aromatic diamine" refers to an aromatic compound having two amino groups.

The term "aromatic diamine residue" refers to the moiety bonded to the two amino groups in an aromatic diamine. This is further illustrated below.

Diamine

Residue

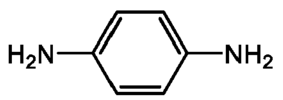

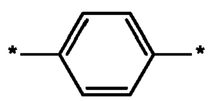

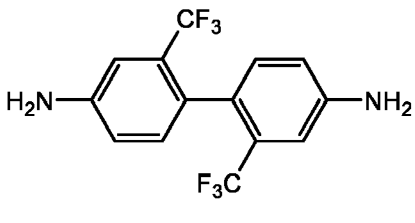

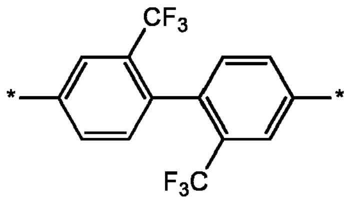

The term "CMOS image sensor," or "CIS" refers to a type of digital image sensor that is an integrated circuit used for measuring light intensity. Image sensors have generally become quite common; finding utility in phones, computers, digital cameras, and automobiles. The two key image sensor technologies are charge-coupled devices (CCD) and complementary metal-oxide-semiconductor (CMOS). Although they were both created a roughly the same time, CCD images dominated the market for many years due to superior image quality. As fabrication technology improved, CMOS imagers eventually became a viable option and are finding uses in an expanding array of end-uses.

The term "coating" refers to a covering that is applied to the surface of an object that is usually referred to as the "substrate." Coatings may have various thicknesses and other properties, depending on the end-use appropriate for a given situation. In some non-limiting embodiments; the coating/substrate combination is used as a single unit, while in some embodiments, the coating is removed from the substrate for stand-alone use. In some non-limiting embodiments, the thus-removed coating is referred to as a film, a thin film, an optical thin film, or the like.

The term "copolymer" refers to a polymer that is derived from more than one species of monomer. Copolymers derived from three species of monomers are sometimes referred to as "terpolymers."

The term "crosslinker" or "cross-linking reagent" refers to a molecule that contains two or more reactive ends capable of chemically attaching to specific functional groups on molecules or polymers. The crosslinked molecules or polymers are chemically joined together by one or more covalent bonds.

The term "curing" refers to a process during which a chemical reaction or physical action takes place; resulting in a harder, tougher, or more stable linkage or substance. In polymer chemistry, "curing" specifically refers to the toughening or hardening of a polymer via cross-linking of polymer chains. Curing processes may be brought about by electron beams, heat, and/or chemical additives.

The term "linear coefficient of thermal expansion (CTE or $\alpha$)" refers to the parameter that defines the amount which a material expands or contracts as a function of temperature. It is expressed as the change in length per degree Celsius and is generally expressed in units of $\mu$m / m / °C or ppm / °C.

$$\alpha = (\Delta L / L0) / \Delta T$$

CTE values may be measured via known methods during the first or second heating scan. The understanding of the relative expansion / contraction characteristics of materials can be an important consideration in the fabrication and/or reliability of electronic and display devices.

The term "electroactive" as it refers to a layer or a material, refers to a layer or material which electronically facilitates the operation of a device. Examples of electroactive materials include, but are not limited to, materials which conduct, inject, transport, or block a charge, where the charge can be either an electron or a hole, or materials which emit radiation or exhibit a change in concentration of electron-hole pairs when receiving radiation.

The term "fused," when applied to aromatic or alicyclic rings refers to an aromatic or alicyclic species that contains two or more joined rings that may share a single atom, two adjacent atoms, or 3 or more atoms.

The term "glass transition temperature (or $T_g$)" refers to the temperature at which a reversible change occurs in an amorphous polymer or in amorphous regions of a semi-crystalline polymer where the material changes suddenly from a hard, glassy, or brittle state to one that is flexible or elastomeric. Microscopically, the glass transition occurs when normally-coiled, motionless polymer chains become free to rotate and can move past each other. $T_g$'s may be measured using differential scanning calorimetry (DSC), thermo-mechanical analysis (TMA), dynamic-mechanical analysis (DMA), or other methods.

The term "haloalkyl" refers to an alkyl group having one or more hydrogen atoms replaced by a halogen atom.

The term "haloalkoxy" refers to an alkoxy group having one or more hydrogen atoms replaced by a halogen atom.

The prefix "hetero" refers to a situation where one or more carbon atoms have been replaced with a different atom. In some embodiments, the heteroatom is O, N, S, or combinations thereof.

The term "high-boiling" refers to a boiling point greater than 130°C.

The term "hindered amine light stabilizer" refers to a class of radical scavengers used for light protection and long-term heat protection of polymers. Hindered amine light stabilizers are compounds that contain a sterically hindered amine functional group, which is designed to react with free radicals and resist other side reactions.

The term "imide" refers to a functional group containing two acyl groups bound to a central nitrogen, i.e., RCO—NR'—COR. The term "bis-imide" refers to the presence of two identical, but separated, imide groups in a single molecule, polymer, or other species.

The term "matrix" refers to a foundation on which one or more layers is deposited in the formation of, for example, an electronic device. Non-limiting examples include glass, silicon, and others.

The term "monomer" refers to a small molecule that chemically bonds during polymerization to one or more monomers of the same or different kind to form a polymer.

The term "nonpolar" refers to a molecule, solvent, or other species in which the distribution of electrons between covalently-bonded atoms is even and there is thus no net electrical charge across them. In some embodiments; nonpolar molecules, solvents, or other species are formed when constituent atoms have the same or similar electronegativities.

The term "optical thin film" refers to a polymeric film whose optical properties make it well-suited to provide specific function in optical devices such as those disclosed herein. Optical thin films may be prepared by any number of methods that are well known to those skilled in the art. The term "optical material" is sometimes used interchangeably by those with skill in the art, particularly when the application does not involve the polymer being directly prepared as a thin film.

The term "organic electronic device" or sometimes "electronic device" refers to a device including one or more organic semiconductor layers or organic materials.

The term "oxygen scavenger" refers to compounds that are added to solutions or formulations that assist in the reduction or removal of oxygen from the solutions or formulations or films made therefrom.

The term "photoacid" refers to molecules which become more acidic upon absorption of light. This is due either to the formation of strong acids upon photodissociation, or to the dissociation of protons upon photo-association (e.g. ring-closing). The term "photoacid generator" refers to a molecule that releases protons upon illumination.

The term "photoinitiator" refers to a molecule that creates one or more reactive species (free radicals, cations or anions) when exposed to UV or visible radiation. Synthetic photoinitiators are sometimes key components in photopolymers like photo-curable coatings, adhesives and dental materials.

The term "polar" refers to a molecule, solvent, or other species in which the distribution of electrons between covalently-bonded atoms is not even. Such species therefore exhibit a large dipole moment which may result from bonds between atoms characterized by significantly-different electronegativities.

The term "polyimide" refers to condensation polymers resulting from the reaction of one or more bifunctional carboxylic acid components with one or more primary diamines or diisocyanates. Polyimides contain the imide structure —CO—NR—CO— as a linear or heterocyclic unit along the main chain of the polymer backbone.

The term "polymer" refers to a large molecule comprising one or more types of monomer residues (repeating units) connected by covalent chemical bonds. By this definition, a polymer encompasses compounds wherein the number of monomer units may range from very few, which more commonly may be called as oligomers, to very many. Non-limiting examples of polymers include homopolymers and non-homopolymers such as copolymers, terpolymers, tetrapolymers and the higher analogues.

The term "polyarylene" refers to a class of polymers that contain benzenoid aromatic components directly joined to one another by carbon-carbon bonds along the main chain of the polymer backbone.

The term "protic" refers to a class of solvents that contain an acidic hydrogen atom and are therefore capable of acting as hydrogen donors. Common protic solvents include formic acid, n-butanol, isopropanol, ethanol, methanol, acetic acid, water, propylene glycol methyl ether (PGME), and others. Protic solvents can be used individually or in various combinations.

The term "reactive," when used in the context of a chemical species or group refers to the propensity of the chemical species or group to undergo a chemical reaction when subject to the appropriate conditions of temperature, pressure, co-reactants, and the like. The chemical species or group can include any number of materials or classes of materials that are known to those with skill in the art.

The term "refractive index" or "index of refraction" is a measure of the bending of a ray of light when it passes from one medium into another. If $i$ is the angle of incidence of a ray in a vacuum (angle between the incoming ray and the perpendicular to the surface of a medium, called the normal) and $r$ is the angle of refraction (angle between the ray in the medium and the normal), the refractive index $n$ is defined as the ratio of the sine of the angle of incidence to the sine of the angle of refraction; i.e., $n = \sin i / \sin r$. Refractive index is also equal to the velocity of light c of a given wavelength in empty space divided by its velocity v in a substance, or $n = c/v$. The refractive index is generally wavelength dependent. The refractive index of a given compound or material may generally be viewed as "low," "intermediate," or "high;" as would be understood by one having skill in the art to which these relative terms may be applied.

The term "satisfactory," when regarding a materials property or characteristic, is intended to mean that the property or characteristic fulfills all requirements / demands for the material in-use.

The term "solubility" refers to the maximum amount of solute that can be dissolved in a solvent at a given temperature. In some embodiments, solubility may be measured or assessed by any number of qualitative or quantitative methods.

The term "substrate" refers to a base material that can be either rigid or flexible and may include one or more layers of one or more materials, which can include, but are not limited to, glass, polymer, metal or ceramic materials or combinations thereof. The substrate may or may not include electronic components, circuits, or conductive members.

The term "surface leveling agent" refers to a formulation additive that reduces the surface tension of a coating being applied to a substrate; wherein surface wetting is improved, and defects are eliminated that can result from a mismatch in surface tensions of the coating and substrate onto which it is applied.

The term "tetracarboxylic acid component" refers to any one or more of the following: a tetracarboxylic acid, a tetracarboxylic acid monoanhydride, a tetracarboxylic acid dianhydride, a tetracarboxylic acid monoester, and a tetracarboxylic acid diester.

The term "thermal acid generator" refers to a compound or compounds that, when heated, are capable of producing a strong acid or acids having a pKa of 2.0 or less. In one non-limiting embodiment, the thermal acid generator comprises a salt wherein a volatile base (e.g., pyridine) buffers a superacid (e.g., a sulfonate), and the mixture is heated above the heat of decomposition of the salt and the boiling point of the buffering base to remove the buffer and yield the strong acid. In another non-limiting embodiment, a thermal acid generator comprises a thermally-unstable buffer that breaks down upon heating to produce a strong acid. The use of thermal acid generators in electronics and displays applications described is described, for example, in U.S. 2014-0120469 A1. A variety of thermal acid generators are commercially available.

The term "transmittance" or "percent transmittance" refers to the percentage of light of a given wavelength impinging on a film that passes through the film so as to be detectable on the other side. Light transmittance measurements in the visible region (380 nm to 800 nm) are particularly useful for characterizing film-color characteristics that are most important for understanding the properties-in-use of the optical thin films disclosed herein.

The term "UV blocker" refers to a compound that mitigates the harmful effects of UV radiation on materials prepared from compositions that contain them.

In a structure where a substituent bond passes through one or more rings as shown below,

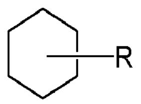

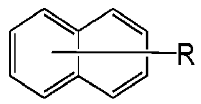

it is meant that the substituent R may be bonded at any available position on the one or more rings.

The phrase "adjacent to," when used to refer to layers in a device, does not necessarily mean that one layer is immediately next to another layer. On the other hand, the phrase "adjacent R groups," is used to refer to R groups that are next to each other in a chemical formula (i.e., R groups that are on atoms joined by a bond). Exemplary adjacent R groups are shown below:

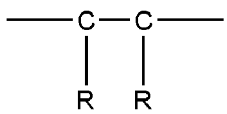

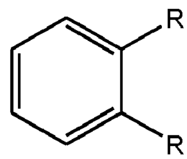

All percentages, ratios, and proportions used herein are based on weight unless otherwise specified.

The present disclosure is directed to a copolymer composition comprising: (a) one or more high refractive index first monomers; (b) one or more second monomers comprising a reactive side chain; and (c) one or more solvents.

The present disclosure is further directed to a copolymer composition comprising: (a) one or more high refractive index first monomers; (b) one or more second monomers comprising a reactive side chain; (c) one or more solvents; (d) a thermally- or photochemically-activated catalyst; and (e) one or more cosolvents.

The present disclosure is further directed to a copolymer composition comprising: (a) one or more high refractive index first monomers; (b) one or more second monomers comprising a reactive side chain; (c) one or more solvents; (d) one or more second copolymer compositions; (e) a thermally- or photochemically-activated catalyst; and (f) one or more cosolvents.

In some non-limiting embodiments, the one or more high refractive index first monomers of the present disclosure have a refractive index measured at 550 nm that is greater than 1.50. In some non-limiting embodiments, the one or more high refractive index first monomers of the present disclosure have a refractive index measured at 550 nm that is greater than 1.60. In some non-limiting embodiments, the one or more high refractive index first monomers of the present disclosure have a refractive index measured at 550 nm that is greater than 1.65. In some non-limiting embodiments, the one or more high refractive index first monomers of the present disclosure have a refractive index measured at 550 nm that is greater than 1.68. In some non-limiting embodiments, the one or more high refractive index first monomers of the present disclosure have a refractive index measured at 550 nm that is greater than 1.70. In some non-limiting embodiments, the one or more high refractive index first monomers of the present disclosure have a refractive index measured at 550 nm that is greater than 1.80.

In some non-limiting embodiments, the one or more high refractive index first monomers of the present disclosure have a refractive index measured at other wavelengths of the visible spectrum. In some non-limiting embodiments, the one or more high refractive index first monomers of the present disclosure have a refractive index measured between 380 nm and 750 nm. In some non-limiting embodiments, the one or more high refractive index first monomers of the present disclosure have a refractive index measured between 400 nm and 700 nm. In some non-limiting embodiments,

the one or more high refractive index first monomers of the present disclosure have a refractive index measured between 450 nm and 650 nm. In some non-limiting embodiments, the one or more high refractive index first monomers of the present disclosure have a refractive index measured between 500 nm and 600 nm.

In some non-limiting embodiments, the one or more high refractive index first monomers of the present disclosure have a refractive index measured at these other wavelengths of the visible spectrum that is greater than 1.50. In some non-limiting embodiments, the one or more high refractive index first monomers of the present disclosure have a refractive index measured at these other wavelengths of the visible spectrum that is greater than 1.60. In some non-limiting embodiments, the one or more high refractive index first monomers of the present disclosure have a refractive index measured at these other wavelengths of the visible spectrum that is greater than 1.65. In some non-limiting embodiments, the one or more high refractive index first monomers of the present disclosure have a refractive index measured at these other wavelengths of the visible spectrum that is greater than 1.68. In some non-limiting embodiments, the one or more high refractive index first monomers of the present disclosure have a refractive index measured at these other wavelengths of the visible spectrum that is greater than 1.70. In some non-limiting embodiments, the one or more high refractive index first monomers of the present disclosure have a refractive index measured at these other wavelengths of the visible spectrum that is greater than 1.80.

In some non-limiting embodiments, the one or more high refractive index first monomers of the present disclosure is an aromatic heterocycle comprising one or more polymerizable functional groups attached to the heteroatom of the aromatic heterocycle. In some non-limiting embodiments, the one or more high refractive index first monomers of the present disclosure is an aromatic heterocycle comprising one or more polymerizable functional groups attached to the heteroatom of the aromatic heterocycle wherein the aromatic heterocycle has 6-30 ring carbons, in some non-limiting embodiments from 6-20 ring carbons, and in some non-limiting embodiments from 6-12 ring carbons. In some non-limiting embodiments, the aromatic heterocycle has at least one ring atom which is selected from the group consisting of O, N, and S.

In some non-limiting embodiments, the aromatic heterocycle is selected from the group consisting of pyridines, carbazoles, furans, pyrroles, thiophenes, imidazoles, and pyrimidines. In some non-limiting embodiments, the aromatic heterocycle is further substituted with additional substituents as disclosed herein.

In some non-limiting embodiments, the one or more high refractive index first monomers of the present disclosure is an aromatic heterocycle comprising one or more polymerizable functional groups attached to the heteroatom of the aromatic heterocycle is represented by the following Formula (1):

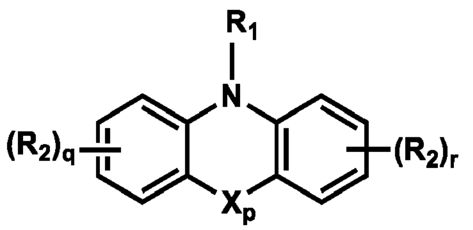

Formula (1)

wherein $R_1$ comprises at least one polymerizable functional group selected from the group consisting of a vinyl group, an epoxy group, an oxetanyl group, an acryloyl group, a methacryloyl group, a styrenyl group, a maleate group, and deuterated analogs of these groups; X is selected from the group consisting of B, N, O, P, Si, and S; $R_2$ is the same or different at each occurrence and is selected from the group consisting of hydrogen, deuterium, a halogen, hydroxyl, carboxyl, carboxylic acid, ester, acetal, aminal, epoxy, oxetanyl, a cyano, a substituted or unsubstituted ($C_1$-$C_{30}$)alkyl, a substituted or unsubstituted deuterated ($C_1$-$C_{30}$)alkyl, a substituted or unsubstituted ($C_2$-$C_{30}$)alkenyl, a substituted or unsubstituted deuterated ($C_2$-$C_{30}$)alkenyl, a substituted or unsubstituted ($C_2$-$C_{30}$)alkynyl, a substituted or unsubstituted deuterated ($C_2$-$C_{30}$)alkynyl, a substituted or unsubstituted ($C_3$-$C_{30}$)cycloalkyl, a substituted or unsubstituted deuterated ($C_3$-$C_{30}$)cycloalkyl, a substituted or unsubstituted ($C_6$-$C_{60}$)aryl, a substituted or unsubstituted deuterated ($C_6$-$C_{60}$)aryl, a substituted or unsubstituted tri($C_1$-$C_{30}$)alkylsilyl, a substituted or unsubstituted deuterated tri($C_1$-$C_{30}$)alkylsilyl, a substituted or unsubstituted tri($C_6$-$C_{30}$)arylsilyl, a substituted or unsubstituted deuterated tri($C_6$-$C_{30}$)arylsilyl, a substituted or unsubstituted di($C_1$-$C_{30}$)alkyl($C_6$-$C_{30}$)arylsilyl, a substituted or unsubstituted deuterated di($C_1$-$C_{30}$)alkyl($C_6$-$C_{30}$)arylsilyl, a substituted or unsubstituted ($C_1$-$C_{30}$)alkyldi($C_6$-$C_{30}$)arylsilyl, a substituted or unsubstituted deuterated ($C_1$-$C_{30}$)alkyldi($C_6$-$C_{30}$)arylsilyl, a substituted or unsubstituted mono- or di-($C_6$-$C_{30}$)arylamino, or a substituted or unsubstituted deuterated mono- or di-($C_6$-$C_{30}$)arylamino; or may be linked to an adjacent substituent(s) to form a substituted or unsubstituted ($C_3$-$C_{30}$), mono- or polycyclic, alicyclic or aromatic ring that may or may not contain deuterium, and

whose carbon atom(s) may be replaced with at least one hetero atom selected from N, O, and S; p = 0 or 1; such that when p =0, Formula 1 represents a carbazole; q and r are the same or different and are 0, 1, 2, 3, or 4.

In some non-limiting embodiments of Formula 1, $R_1$ is selected from the group consisting of a vinyl group, an acryloyl group, and a methacryloyl group. In some non-limiting embodiments of Formula 1, $R_1$ is a vinyl group. In some non-limiting embodiments of Formula 1, X is selected from the group consisting of N, O, and S. In some non-limiting embodiments of Formula 1, X is N. In some non-limiting embodiments of Formula 1, $R_2$ is the same or different at each occurrence and is selected from the group consisting of hydrogen, a halogen, a substituted or unsubstituted ($C_1$-$C_{30}$)alkyl, and a substituted or unsubstituted ($C_6$-$C_{60}$)aryl. In some non-limiting embodiments of Formula 1, $R_2$ is linked to an adjacent substituent(s) to form a substituted or unsubstituted ($C_3$-$C_{30}$), mono- or polycyclic, alicyclic or aromatic ring, whose carbon atom(s) may be replaced with at least one hetero atom selected from N, O, and S. In some non-limiting embodiments of Formula 1, $R_2$ is the same or different at each occurrence and is selected from the group consisting of hydrogen, a halogen, and a substituted or unsubstituted ($C_1$-$C_{30}$)alkyl. In some non-limiting embodiments of Formula 1, $R_2$ is hydrogen. In some non-limiting embodiments of Formula 1, $R_2$ is the same at each occurrence. In some non-limiting embodiments of Formula 1, $R_2$ is different at each occurrence. In some non-limiting embodiments of Formula 1, p =0 and Formula 1 represents a carbazole. In some non-limiting embodiments of Formula 1, p =1. In some non-limiting embodiments of Formula 1, q is 0, 1, 2, 3, or 4. In some non-limiting embodiments of Formula 1, r is 0, 1, 2, 3, or 4. In some non-limiting embodiments of Formula 1 q and r are the same. In some non-limiting embodiments of Formula 1, q and r are different.

In some non-limiting embodiments, the compound having Formula 1 is selected from the group consisting of N-vinylcarbazole; N-allylcarbazole; N-glycidyl-carbazole; N-(meth)acryloylcarbazole; carbazoylethyl (meth)acrylate, carbazoylethoxyethyl (meth)acrylate, and carbazoyl (2-methylethyl)(meth)acrylate.

Some non-limiting examples of compounds having Formula 1 are:

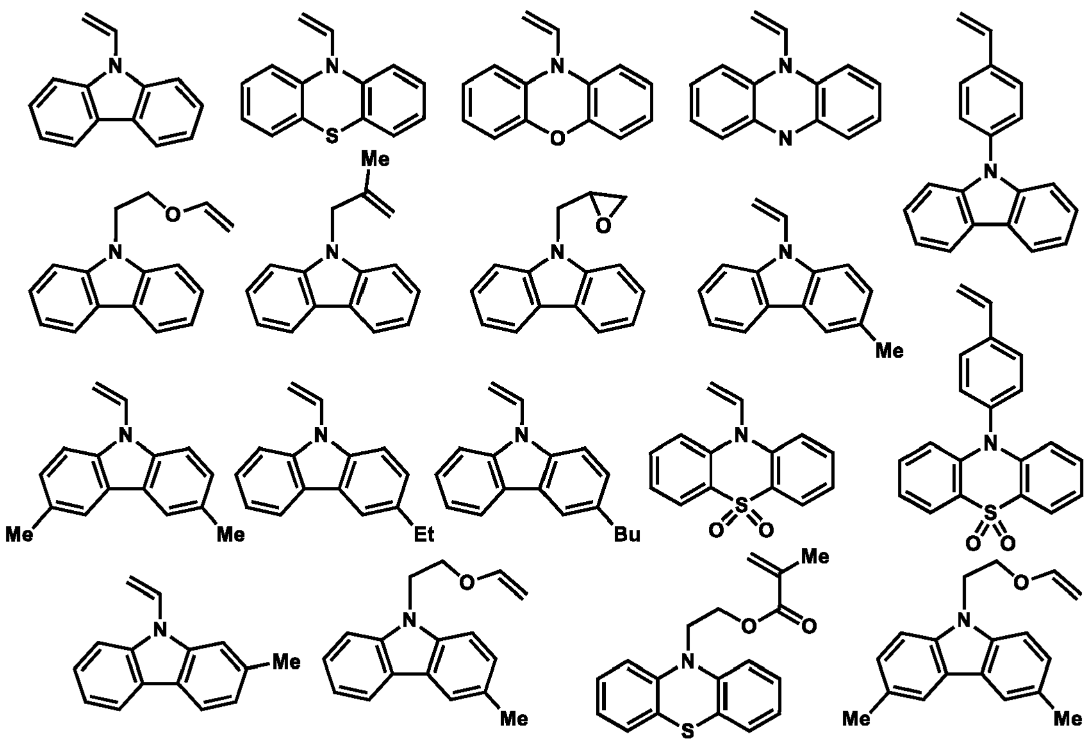

In some non-limiting embodiments, the one or more second monomers comprising a reactive side chain is selected from the group with reactive side chains consisting of hydroxyl, carboxyl, carboxylic acid, ester, acetal, aminal, epoxy, oxetanyl, vinyl, vinyl ether, acryloyl, and methacryloyl. In some non-limiting embodiments, the one or more second monomers comprising a reactive side chain contains at least one deuterium per monomer.

In some non-limiting embodiments, the one or more second monomers comprising a reactive side chain is selected from the group consisting of acrylic acid, (meth)acrylic acid, methyl (meth)acrylate, ethyl (meth)acrylate, N-propyl (meth)acrylate, isopropyl (meth)acrylate, n-butyl (meth)acrylate, isobutyl (meth)acrylate, t-butyl (meth)acrylate, methyl 2-ethylhexyl (meth)acrylate, glycidyl (meth)acrylate cyclohexyl acrylate, benzyl (meth)acrylate, 2-hydroxyethyl acrylate, 2-hydroxyethyl (meth) acrylate, 2-carboxyethyl acrylate, 2-carboxyethyl methacrylate, mono(2-acryloyloxyethyl)succinate, mono(2-methacryloyloxyethyl)succinate, styrene, hydroxystyrene, styrene-carboxylic acid, vinyltoluene,

α-methylstyrene, myrcene, maleimide, N-benzylmaleimide, N-cyclohexylmaleimide, methyl-2,2 '-[oxybis (methylene)] bis-2-propenoate, diethyl-2,2 '-[oxybis (methylene)] bis-2-propenoate, butadiene, isoprene, ethylene, propylene, vinyl chloride, acrylonitrile, vinyl acetate, vinyl phenoxy benzocyclobutene, and the like and combinations thereof.

In some non-limiting embodiments, the one or more second monomers comprising a reactive side chain does not comprise an aromatic ring. In some non-limiting embodiments, the one or more second monomers comprising a reactive side chain comprises an aromatic ring.

In some non-limiting embodiments, the copolymer composition comprises one second monomer comprising a reactive side chain. In some non-limiting embodiments, the copolymer composition comprises two second monomers comprising a reactive side chain. In some non-limiting embodiments, the copolymer composition comprises three or more second monomers comprising a reactive side chain. In some non-limiting embodiments with two second monomers comprising a reactive side chain, the first second monomer comprising a reactive side chain is different from the second second monomer comprising a reactive side chain. In some non-limiting embodiments with three or more second monomers comprising a reactive side chain, each of the second monomers comprising a reactive side chain is different from the other second monomers comprising a reactive side chain.

In some non-limiting embodiments of the copolymer composition, the second, third, or additional second monomers comprising a reactive side chain is selected from the group consisting of acrylic acid, (meth)acrylic acid, methyl (meth)acrylate, ethyl (meth)acrylate, N-propyl (meth)acrylate, isopropyl (meth)acrylate, n-butyl (meth)acrylate, isobutyl (meth)acrylate, t-butyl (meth)acrylate, methyl 2-ethylhexyl (meth)acrylate, glycidyl (meth)acrylate cyclohexyl acrylate, benzyl (meth)acrylate, 2-hydroxyethyl acrylate, 2-hydroxyethyl (meth) acrylate, 2-carboxyethyl acrylate, 2-carboxyethyl methacrylate, mono(2-acryloyloxyethyl)succinate, mono(2-methacryloyloxyethyl)succinate, styrene, hydroxystyrene, styrene-carboxylic acid, vinyltoluene, α-methylstyrene, myrcene, maleimide, N-benzylmaleimide, N-cyclohexylmaleimide, methyl-2,2 '-[oxybis (methylene)] bis-2-propenoate, diethyl-2,2 '-[oxybis (methylene)] bis-2-propenoate, butadiene, isoprene, ethylene, propylene, vinyl chloride, acrylonitrile, vinyl acetate, vinyl phenoxy benzocyclobutene,

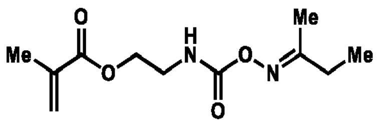 , 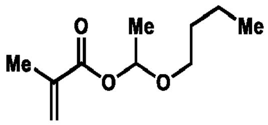 , 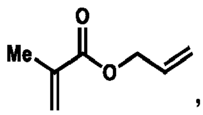 , and 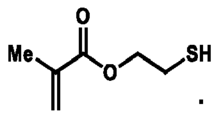 .

In some non-limiting embodiments of the copolymer composition, the second second monomer comprising a reactive side chain is present in an amount less than the first second monomer comprising a reactive side chain. In some non-limiting embodiments of the copolymer composition, the third second monomer comprising a reactive side chain is present in an amount less than the first or second second monomers comprising a reactive side chain. In some non-limiting embodiments of the copolymer composition, the fourth second monomer comprising a reactive side chain is present in an amount less than the first, second, or third second monomers comprising a reactive side chain.

In some non-limiting embodiments of the copolymer composition, the third monomer may include a side chain that has a high inherent optical density. In some non-limiting embodiments of the copolymer composition, the second or additional second monomers may possess a side chain comprising a functional group with high inherent optical density or high molar polarization, as would be known to one skilled in the art. Monomers comprising such side chains may be selected from the group consisting of 4-bromostyrene; 4-thiophenyl-styrene; (4-bromophenyl) methacrylate; 4-thio(benzothiazole) styrene;

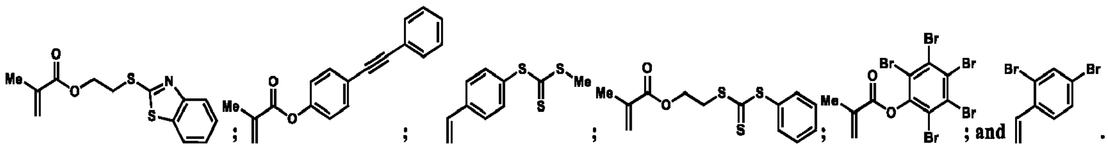

; ; ; ; ; and .

In some non-limiting embodiments, the composition optionally comprises the copolymer comprising one or more high refractive index first monomers and one or more second monomers comprising a reactive side chain and one or more additional polymers or copolymers. These additional polymer or copolymers may include poly(acrylic acid), polyacrylates, polymethacrylates, polyacrylonitriles, polystyrene, poly(hydroxystyrene), polyarylenes, polyimides, poly(amic acids) polyurethanes, polycarbonates, polyamides, polysilanes, polysiloxanes, silicones, polymeric colloidal silica, polymeric ionic liquids, and the like and combinations thereof.

In some non-limiting embodiments, the composition optionally comprises the copolymer comprising one or more high refractive index first monomers and one or more second monomers comprising a reactive side chain and one or more additional polymers or copolymers. These additional polymers or copolymers may optionally comprise one or

more high refractive index first monomer of the same composition as the first copolymer, and optionally a second second monomer comprising a reactive side chain of a different composition as the first second monomer comprising a reactive side chain. Further, addition of the second polymer does not negatively impact the overall optical properties of the composition for the applications disclosed herein.

In some non-limiting embodiments, the composition optionally comprises the copolymer comprising one or more high refractive index first monomers and one or more second monomers comprising a reactive side chain and one or more additional polymers or copolymers. The additional polymer or copolymer may comprise first, second or third monomers or with side chains possessing high optical density, or reactive side chains, or polar protic side chains and the like and combinations thereof. In some non-limiting embodiments, copolymers comprising such include those corresponding to formula (2):

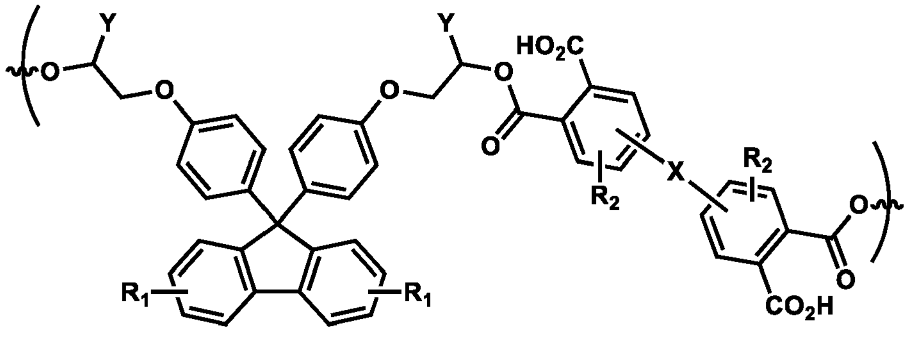

Formula (2)

wherein Y comprises at least one polymerizable functional group selected from the group consisting of a vinyl group, an acetylene group, an epoxy group, an oxetanyl group, an acryloyl group, a methacryloyl group, an amine group, a sulfide group, and deuterated analogs of these groups; X is selected from the group consisting of no linker, or substituted B, N, O, P, Si, and S; $R_1$ and $R_2$ groups are the same or different at each occurrence and is selected from the group consisting of hydrogen, deuterium, a halogen, a cyano, a substituted or unsubstituted hydroxyl, a substituted or unsubstituted carbonyl, a substituted or unsubstituted carboxyl, a substituted or unsubstituted amide, a substituted or unsubstituted amine, a substituted or unsubstituted sulfide, a substituted or unsubstituted sulfone, a substituted or unsubstituted sulfonate a substituted or unsubstituted ($C_1$-$C_{30}$)alkyl, a substituted or unsubstituted deuterated ($C_1$-$C_{30}$)alkyl, a substituted or unsubstituted ($C_2$-$C_{30}$)alkenyl, a substituted or unsubstituted deuterated ($C_2$-$C_{30}$)alkenyl, a substituted or unsubstituted ($C_2$-$C_{30}$)alkynyl, a substituted or unsubstituted deuterated ($C_2$-$C_{30}$)alkynyl, a substituted or unsubstituted ($C_3$-$C_{30}$)cycloalkyl, a substituted or unsubstituted deuterated ($C_3$-$C_{30}$)cycloalkyl, a substituted or unsubstituted ($C_6$-$C_{60}$)aryl, a substituted or unsubstituted deuterated ($C_6$-$C_{60}$)aryl, a substituted or unsubstituted tri($C_1$-$C_{30}$)alkylsilyl, a substituted or unsubstituted deuterated tri($C_1$-$C_{30}$)alkylsilyl, a substituted or unsubstituted tri($C_6$-$C_{30}$)arylsilyl, a substituted or unsubstituted deuterated tri($C_6$-$C_{30}$)arylsilyl, a substituted or unsubstituted di($C_1$-$C_{30}$)alkyl($C_6$-$C_{30}$)arylsilyl, a substituted or unsubstituted deuterated di($C_1$-$C_{30}$)alkyl($C_6$-$C_{30}$)arylsilyl, a substituted or unsubstituted ($C_1$-$C_{30}$)alkyldi($C_6$-$C_{30}$)arylsilyl, a substituted or unsubstituted deuterated ($C_1$-$C_{30}$)alkyldi($C_6$-$C_{30}$)arylsilyl, a substituted or unsubstituted mono- or di-($C_6$-$C_{30}$)arylamino, or a substituted or unsubstituted deuterated mono- or di-($C_6$-$C_{30}$)arylamino; or may be linked to an adjacent substituent(s) to form a substituted or unsubstituted ($C_3$-$C_{30}$), mono- or polycyclic, alicyclic or aromatic ring that may or may not contain deuterium, and whose carbon atom(s) may be replaced with at least one hetero atom selected from N, O, and S; p = 0 or 1; such that when p =0, Formula 1 represents a carbazole; q and r are the same or different and are 0, 1, 2, 3, or 4. Some non-limiting examples of polymers having formula (2) are:

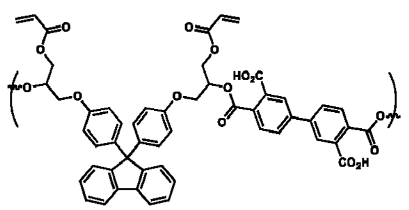

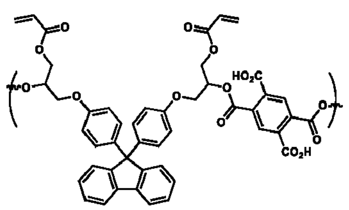

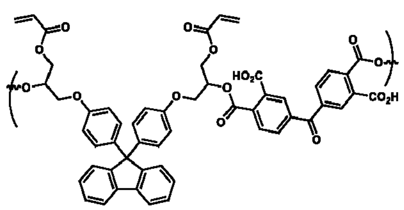

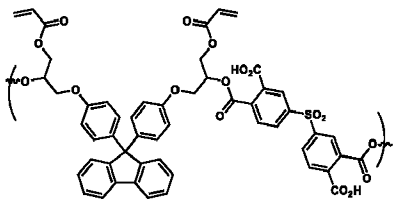
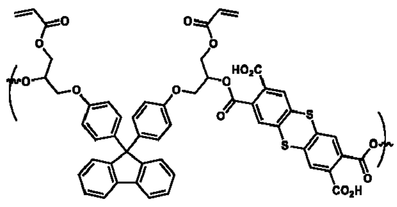
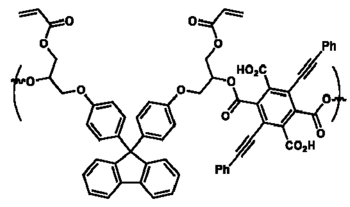

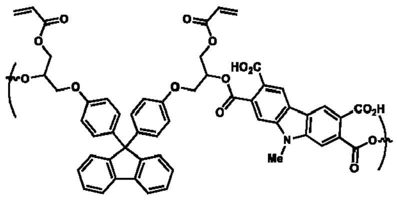
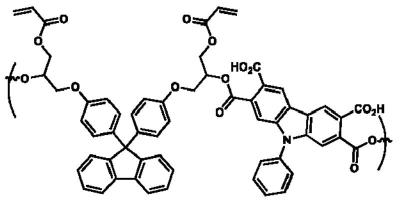
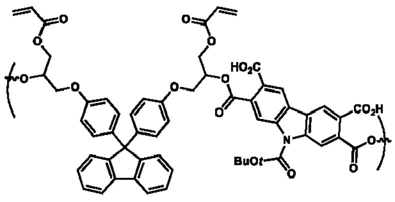

In some non-limiting embodiments, the copolymer composition comprises a photochemically-activated catalyst. In some non-limiting embodiments, the photochemically-activated catalyst is selected from the group consisting of Cyracure™ UVI-6970, Cyracure™ UVI-6974, Cyracure™ UVI-6990, Cyracure™ UVI-950, Irgacure® 250, Irgacure® 261, Irgacure® 264, SP-150, SP-151, SP-170, Optmer SP-171, CG-24-61, DAICAT II, UVAC1590, UVAC1591, CI-2064, CI-2638, CI- 2624, CI-2481 CI-2734, CI-2855, CI-2823, CI-2758, CIT-1682, PI-2074, FFC509, BBI-102, BBI-101, BBI-103, MPI-103, TPS-103, MDS-103, DTS-103, NAT-103, NDS-103, CD-1010, CD-1011, CD-1012, CPI-100P, CPI-101A, MIPHOTO TPA-517, MIPHOTO BCF-530D, and the like and combinations thereof.

In some non-limiting embodiments, the copolymer composition comprises a thermally-activated catalyst. In some non-limiting embodiments, the thermally-activated catalyst is selected from the group consisting of San-Aid SI-45 (Sanshin Chemical Industry), San-Aid SI-47 (Sanshin Chemical Industry), San-Aid SI-60 (Sanshin Chemical Industry), San-Aid SI-60L (Sanshin Chemical Industry), San-Aid SI-80L (Sanshin Chemical Industry), San-Aid SI-80L (Sanshin Chemical Industry), San-Aid SI-100 (Sanshin Chemical Industry), San-Aid SI-100L (Sanshin Chemical Industry), San-Aid SI-110L (Sanshin Chemical Industry), San-Aid SI-145 (Sanshin Chemical Industry), San-Aid SI-150 (Sanshin Chemical Industry), San-Aid SI-160 (Sanshin Chemical Industry), San-Aid SI-110L (Sanshin Chemical Industry), San-Aid SI-180L (Sanshin Chemical Industry), diazonium salts, iodonium salts, sulfonium salts, phosphonium salts, selenium salts, oxonium salts, ammonium salts, metal chelates, trimethylpyridinium *p*-toluenesulfonate, CXC-1821 (King Industries Specialty Chemicals), CXC-2689 (King Industries Specialty Chemicals), CXC-2678 (King Industries Specialty Chemicals), CXC-1614 (King Industries Specialty Chemicals), CXC-1615 (King Industries Specialty Chemicals), CXC-1767 (King Industries Specialty Chemicals), CXC-2172 (King Industries Specialty Chemicals), CXC-2179 (King Industries Specialty Chemicals), and the like and combinations thereof.

Suitable solvents and cosolvents useful in the preparation of the copolymer compositions disclosed herein are generally those that will result in copolymer films prepared therefrom exhibiting uniform film quality when spin-coated at target thicknesses. The solvents and additional solvents are generally organic. Non-limiting embodiments of such solvents and additional solvents include ethers, ketones, esters, alcohols, and aromatic hydrocarbons. In some non-limiting embodiments, the solvent and/or cosolvent is selected from the group consisting of propylene glycol methyl ether, propylene glycol methyl ether acetate, methyl isobutyl ketone, methyl ethyl ketone, methyl propyl ketone, ethyl ethoxypropionate, methyl isoamyl ketone, dimethyl ketone, cyclopentanone, benzyl benzoate, cyclohexanone, methyl 2-hydroxyl isobutyrate, ethyl acetate, ethyl lactate, butyl acetate, methanol, butanol, isopropyl alcohol, N-methylpyrrolidinone, dimethylacetamide, dimethylsulfoxide, benzyl benzoate, γ-butyrolactone, isobutyl isobutyrate, *n*-heptane, and the like and combinations thereof. In some non-limiting embodiments, the solvent and/or cosolvent is selected from the group consisting of methyl isobutyl ketone, methyl ethyl ketone, methyl propyl ketone, methyl isoamyl ketone, dimethyl ketone, cyclopentanone, and the like and combinations thereof. In some non-limiting embodiments, the copolymer composition disclosed herein comprises one solvent. In some non-limiting embodiments, the copolymer composition disclosed herein comprises two or more solvents and/or additional solvents.

In some non-limiting embodiments of the copolymer composition, the one or more high refractive index first monomers and the one or more second monomers comprising a reactive side chain are present in a mole ratio of 20:1 to 1:1, in some non-limiting embodiments 15:1 to 3:1, in some non-limiting embodiments 10:1 to 5:1, in some non-limiting embodiments 8:1 to 6:1, in some non-limiting embodiments 8:1, in some non-limiting embodiments 7.5:1, in some non-limiting embodiments 7:1, in some non-limiting embodiments 6.9:1, in some non-limiting embodiments 6.8:1, in some non-limiting embodiments 6.7:1, in some non-limiting embodiments 6.6:1, in some non-limiting embodiments 6.5:1, in some non-limiting embodiments 6.4:1, in some non-limiting embodiments 6.3:1, in some non-limiting embodiments 6.2:1, in some non-limiting embodiments 6.1:1, in some non-limiting embodiments 6:1, in some non-limiting embodiments 5:1,

in some non-limiting embodiments 2:1, in some non-limiting embodiments 1.1:1, and in some non-limiting embodiments 1:1.

In some non-limiting embodiments of the copolymer composition, the one or more high refractive index first monomers and the thermally- or photochemically-activated catalyst are present in a mole ratio of 10,000:1 to 1:1, in some non-limiting embodiments from 5,000:1 to 1:1, in some non-limiting embodiments 1,000:1 to 1:1, in some non-limiting embodiments 4,400:1, in some non-limiting embodiments 100:1 to 1:1, in some non-limiting embodiments 75:1 to 10:1, in some non-limiting embodiments 60:1 to 10:1, in some non-limiting embodiments 50:1 to 25:1, in some non-limiting embodiments 40:1 to 30:1, in some non-limiting embodiments 40:1, in some non-limiting embodiments 39:1, in some non-limiting embodiments 38:1, in some non-limiting embodiments 37:1, in some non-limiting embodiments 36:1, in some non-limiting embodiments 35:1, in some non-limiting embodiments 34:1, in some non-limiting embodiments 33:1, in some non-limiting embodiments 32:1, in some non-limiting embodiments 31:1, in some non-limiting embodiments 30:1, in some non-limiting embodiments 25:1, in some non-limiting embodiments 20:1, and in some non-limiting embodiments 10:1.

In some non-limiting embodiments of the copolymer composition, the one or more solvents is present in a weight ratio of 90% of the copolymer composition, in some non-limiting embodiments 80%, in some non-limiting embodiments 70%, in some non-limiting embodiments 60%, in some non-limiting embodiments 50%, in some non-limiting embodiments 40%, in some non-limiting embodiments 35%, in some non-limiting embodiments 30%, in some non-limiting embodiments 25%, and in some non-limiting embodiments 20%.

The copolymer composition as disclosed herein can be polymerized and cured to form the corresponding copolymer solid. It can be directly cast as a film, applied as a coating or poured into one or more non-solvents to precipitate the oligomer or copolymer. Water, methanol, ethanol and other similar polar liquids such as glycol ethers are typical non-solvents which can be used to precipitate the copolymer. Solid copolymer may be dissolved and processed from a suitable organic solvent described above, or from organic solvents typically used in the electronics industry, such as propylene glycol methyl ether (PGME), propylene glycol methyl ether acetate (PGMEA), methyl 3-methoxypropionate (MMP), ethyl lactate, n-butyl acetate, anisole, N-methyl pyrrolidone, gamma-butyrolactone (GBL), ethoxybenzene, benzyl propionate, benzyl benzoate, propylene carbonate, and mixtures thereof. Mixtures of organic solvents may also be used, such as a mixture comprising one or more of anisole, ethoxybenzene, PGME, PGMEA, GBL, MMP, n-butyl acetate, benzyl propionate and benzyl benzoate in combination with one or more additional organic solvents, and more preferably a mixture comprising two or more of anisole, ethoxybenzene, PGME, PGMEA, GBL, MMP, n-butyl acetate, benzyl propionate, and benzyl benzoate. When a mixture of solvents is used, the ratio of solvents is generally not critical and may vary from 99:1 to 1:99 w/w. It will be appreciated by those skilled in the art that the concentration of the copolymer in the organic reaction solvent may be adjusted by removing a portion of the organic solvent, or by adding more of the organic solvent, as may be desired.

For coating formation, the coating copolymer compositions disclosed herein can be applied by spin-coating, dipping, drop-casting, roller-coating, screen printing, ink-jet printing, gravure or other conventional coating techniques. In the electronics manufacturing industry, spin-coating and slot-die coating are preferred methods to take advantage of existing equipment and processes. In spin-coating, the solids content of the composition may be adjusted, along with the spin speed, to achieve a desired thickness of the composition on the surface it is applied to. Typically, the present compositions are spin-coated at a spin speed of 400 to 4000 rpm. The amount of the composition dispensed on the substrate depends on the total solids content in the composition, the desired thickness of the resulting coating layer, and other factors well-known to those skilled in the art.

Substrates onto which the materials may be coated are those generally used in the art. In some non-limiting embodiments, the substrates used are selected from the group consisting of silica, Si wafers, silicon nitride, silicon oxynitride, silicon carbide, silicon-germanium, gallium-arsenide, indium-phosphide, aluminum nitride, alumina, glass, and the like. In some non-limiting embodiments, the substrates used are selected from the group consisting of silica, Si wafers, silicon nitride, and silicon carbide. In some non-limiting embodiments, the substrate used is Si wafers. In some non-limiting embodiments, the substrate used is glass. In some non-limiting embodiments, the substrates used are cured polymeric films deposited on any of the aforementioned materials.

The thickness of the coating and / or optical thin film is not particularly limited and will depend, for example, on the particular application or use. In some non-limiting embodiments, the thickness of the coating and / or optical thin film is between 10 nm and 100 μm. In some non-limiting embodiments, the thickness of the coating and / or optical thin film is between 100 nm and 10 μm. In some non-limiting embodiments, the thickness of the coating and / or optical thin film is between 500 nm and 1 μm. In some non-limiting embodiments, the thickness of the coating and / or optical thin film is between 1 μm and 10 μm, in some non-limiting embodiments between 1 μm and 5 μm, in some non-limiting embodiments between about 1 μm and 2 μm, in some non-limiting embodiments 1.1 μm, in some non-limiting embodiments 1.2 μm, in some non-limiting embodiments 1.3, in some non-limiting embodiments 1.4 μm, in some non-limiting embodiments 1.5 μm, in some non-limiting embodiments 1.6 μm, in some non-limiting embodiments 1.7 μm, in some non-limiting embodiments 1.8 μm, and in some non-limiting embodiments 1.9 μm.

Generally, after being coated on a substrate surface, the copolymer composition is heated (soft baked) to remove any organic solvent present. Typical baking temperatures are from 90 to 140 °C, although other suitable temperatures may be used. Such baking to remove residual solvent is typically done for approximately 30 sec. to 2 min., although longer or shorter times may suitably be used. Following solvent removal, a layer, film or coating of the copolymer on the substrate surface is obtained.

After the soft-bake step, the coating comprising the copolymer composition may optionally be patterned to create features upon the substrate. Features are typically formed by exposing portions of the coating to ultraviolet light for a period of time to cross-link selected areas of the coating, and then rinsing away the remaining, un-crosslinked area of the of the coating with a developer to remove substantially all of the coating. Depending on the particular copolymer and components of the composition, the patterning may cause further change to the copolymer, for example, through one or more of polymerization, condensation, or cross-linking. The patterning step is typically conducted in a mask aligner. The wavelength, time and intensity of the ultraviolet light exposure in the patterning step will depend, on the particular copolymer composition, and the layer thickness. In some non-limiting embodiments, the dried coating was exposed, through a mask having a pattern consisting of square holes 1-100 μm in size, to light at an exposure rate of 1 to 200 mJ/cm$^2$ based on a wavelength of 365 nm for a time period of 1-120 seconds using an aligner (model name: Suss MA6), which emits light having a wavelength of 200 nm to 450 nm (USHIO 350mW/h). In some non-limiting embodiments, the developer used is an aqueous solution of 2.38 wt % tetramethylammonium hydroxide through stream nozzles at 23° C. for 70 seconds.

After the soft-bake step, the coating is typically cured at elevated temperature to remove substantially all of the solvent from the polymeric layer, thereby forming a tack-free coating and improving adhesion of the layer to the underlying structure. Depending on the particular copolymer and components of the composition, the cure may cause further change to the copolymer, for example, through one or more of oxidation, outgassing, polymerization, condensation, or cross-linking. The cure is typically conducted on a hotplate or in an oven. The cure can be conducted, for example, in an atmosphere of air or inert gas such as nitrogen, argon or helium, or can be conducted under vacuum. In one non-limiting embodiment, the polymeric layer is cured in an inert gas atmosphere. In one non-limiting embodiment, the polymeric layer is cured under ambient atmospheric conditions. The temperature and time for the cure will depend, for example, on the particular copolymer and solvent of the composition, and the layer thickness. In some non-limiting embodiments, cure temperatures are from 100 to 450 °C. In some non-limiting embodiments, cure temperatures are 300 to 400 °C, or from 325 to 350 °C. In coatings wherein the copolymer layer comprises a crosslinker and/or a thermal acid generator (see below), lower cure temperatures can sometimes be used. In some non-limiting embodiments, these lower cure temperatures are from 50 to 250 °C. In some non-limiting embodiments, these lower cure temperatures are from 150 to 200 °C. In one non-limiting embodiment, wherein the copolymeric layer comprises a crosslinker and a thermal acid generator, the cure temperature is 200 °C. In some non-limiting embodiments, the cure time is from 30 seconds to two hours. In one non-limiting embodiment, the cure time is 5 minutes. In some non-limiting embodiments, the cure time is from 10 minutes to 60 minutes. In one non-limiting embodiment, the cure time is 30 minutes. The cure can be conducted in a single step or in multiple steps. The cure can be conducted by heating the copolymer composition layer at constant temperature or with a varied temperature profile such as a ramped or terraced temperature profile.

Cured copolymer materials, thin films, and the like are generally characterized by compositions corresponding to those as disclosed herein by the embodiments for the copolymer formulations, generally without the solvent component, (d), which is removed via the processes described herein.

The present disclosure is further directed to a formulation comprising (a) a copolymer comprising one or more high refractive index first monomers and one or more second monomers comprising a reactive side chain; and (b) one or more solvents.

The present disclosure is further directed to a formulation comprising (a) a copolymer comprising one or more high refractive index first monomers and one or more second monomers comprising a reactive side chain; (b) a crosslinker; (c) a thermal acid generator; (d) an antioxidant; (e) a surfactant; and (f) one or more solvents and / or cosolvents.

In some non-limiting embodiments, the formulation disclosed herein additionally comprises one or more components selected from the group consisting of surface leveling agents, photoinitiators, photoacid generators, oxygen scavengers, UV blockers, and hindered-amine light stabilizers.

Non-limiting embodiments of the copolymer comprising one or more high refractive index first monomers and one or more second monomers comprising a reactive side chain in the formulation are generally the same as those disclosed herein for the one or more high refractive index first monomers and one or more second monomers comprising a reactive side chain in the copolymer composition. Non-limiting examples of specific copolymers in the formulation include:

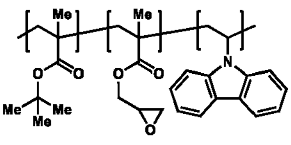
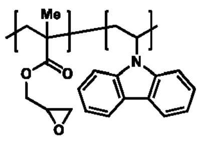
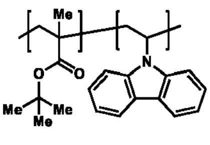
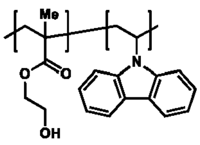
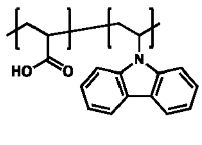

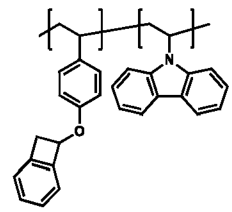
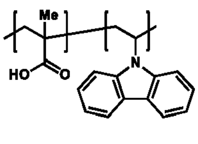
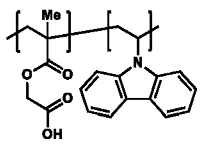
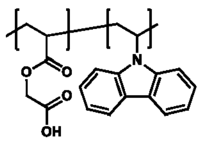
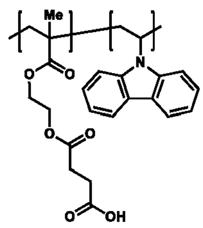
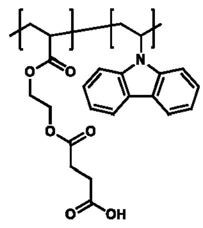

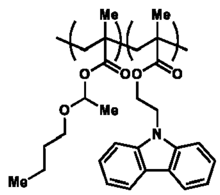
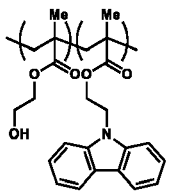
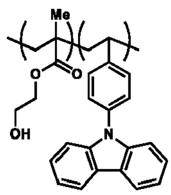
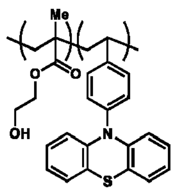
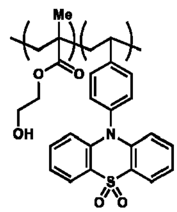
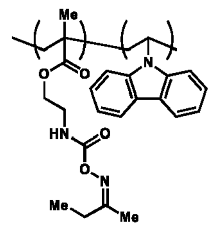

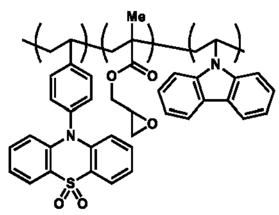
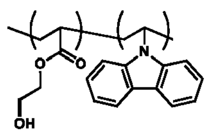
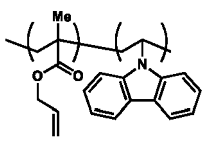
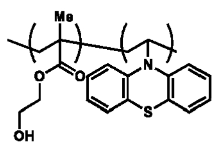
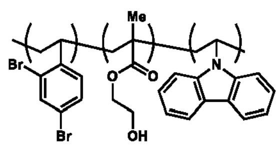

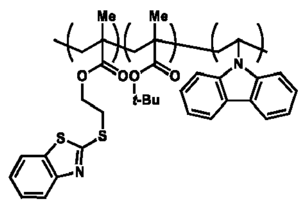
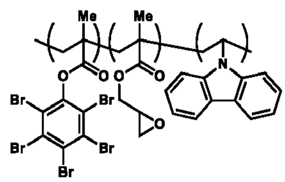
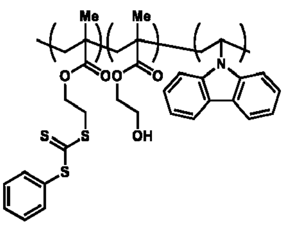
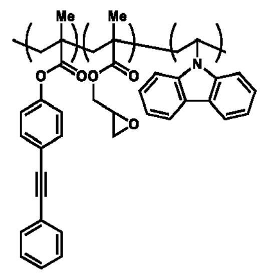

In some non-limiting embodiments, the formulation comprises a crosslinker. In some non-limiting embodiments, the crosslinker is referred to as a crosslinking compound or as another term that would be known to one of skill in the art. Depending on the particular copolymer in the formulation, it may be desirable to include a crosslinker in the formulation, for example, to provide improved mechanical properties such as strength or elasticity to the copolymer in the formulation. In some non-limiting embodiments of the formulation disclosed herein, the crosslinker is selected from the group consisting of diamine compounds, melamine compounds, hemiaminal compounds, guanamine compounds, benzo-quanamine compounds, glycoluril compounds, urea compounds, epoxy compounds, isocyanate compounds, azide compounds, hydroxide-containing compounds, and alkenyl compounds.

Suitable crosslinkers will depend on the copolymer in the formulation and may be chosen, for example, from: melamine compounds such as hexamethylol melamine, hexamethoxymethyl melamine, hexamethylol melamine compounds having 1 to 6 methylol groups, methoxymethylated, hexamethoxyethyl melamine, hexacyloxymethyl melamine, and hexamethylol melamine compounds having 1 to 6 methylol groups acyloxymethylated; hemiaminal compounds such as 1,3,4,6-Tetrakis(methoxymethyl)glycoluril and hexa-(methoxymethyl)melamine, 1,3-bis(methoxymethyl)-2-imidazolidinone ; guanamine compounds such as tetramethylol guanamine, tetramethoxymethyl guanamine, tetramethylol guanamine compounds having 1 to 4 methylol groups methoxymethylated, tetramethoxyethyl guanamine, tetraacyloxyguanamine, tetramethylol guanamine compounds having 1 to 4 methylol groups acyloxymethylated, and benzo-

quanamine compounds; glycoluril compounds having substituted thereon at least one group chosen from methylol, alkoxymethyl and acyloxymethyl groups such as tetramethylol glycoluril, tetramethoxyglycoluril, tetramethoxymethyl glycoluril, tetramethylol glycoluril compounds having 1 to 4 methylol groups methoxymethylated, and tetramethylol glycoluril compounds having 1 to 4 methylol groups acyloxymethylated; urea compounds having substituted thereon at least one group chosen from methylol, alkoxymethyl and acyloxymethyl groups such as tetramethylol urea, tetramethoxymethyl urea, tetramethylol urea compounds having 1 to 4 methylol groups methoxymethylated, and tetramethoxyethyl urea; epoxy compounds such as such as tris(2,3-epoxypropyl)isocyanurate, trimethylolmethane triglycidyl ether, trimethylolpropane triglycidyl ether, bisphenol A diglycidyl ether, bisphenol S diglycidyl ether, HP-4032 (DIC Corp.), HP-4700 (DIC Corp.), HP-4770 (DIC Corp), 4,4'-methylenebis(*N*,*N*-diglycidalaniline), tris(4 hydroxy-phenyl)methane triglycidal ether, 3,4-epoxycyclohexylmethyl-3,4-epoxycyclohexanecarboxylate, TEPIC-UC (Nissan Chemical), tetrakis[(epoxycyclohexyl) ethyl]tetramethylcyclotetrasiloxane and triethylolethane triglycidyl ether; isocyanate compounds such as the blocked isocyanate Desmodur BL 3475 SA/SN; azide compounds; hydroxy-containing compounds; diamine-containing compounds such as 4,4'-diaminodiphenyl sulfone; or compounds having a double bond such as an alkenyl ether group.

Non-limiting embodiments of these crosslinking compounds are chosen to react with nucleophilic side chains of the copolymer under appropriate conditions. Such crosslinking compounds will have an electrophilically reactive cross-linking group. Examples of such cross-linkers are:

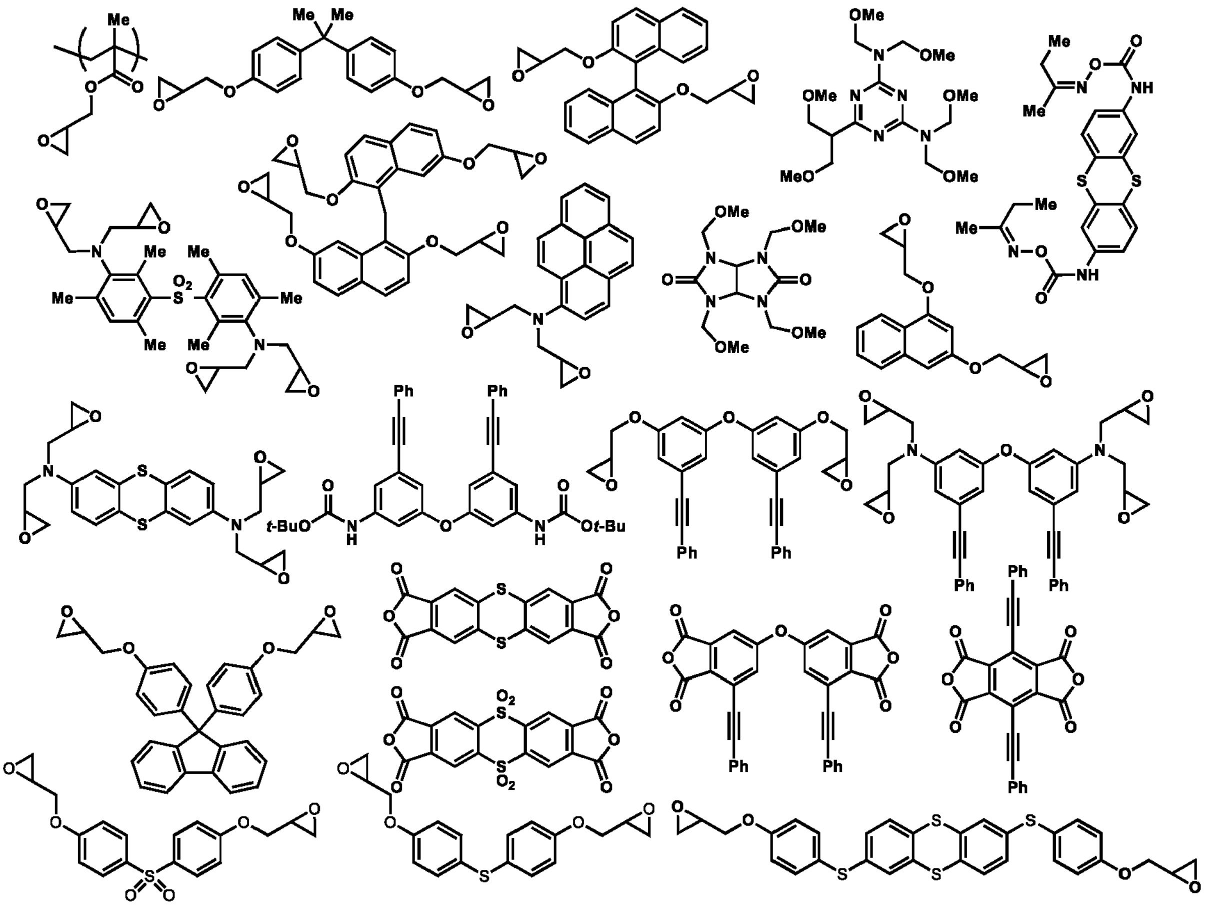

Other non-limiting embodiments of these crosslinking compounds contain metallic oxides, or metal-oxide oligomeric compositions. Such crosslinking compounds will have reactive cross-linking groups as functional side chains. Their composition can be generally expressed as:

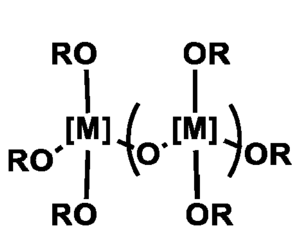

where R is an alkyl or aryl functional group, and M is one of the following metals: Ti, Zn, Zr, V, Hf, Sn, La, Rh, Ce, U, Cu, La, Cr. Examples of such cross-linkers are:

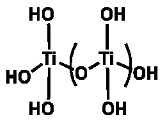 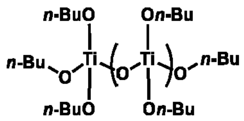 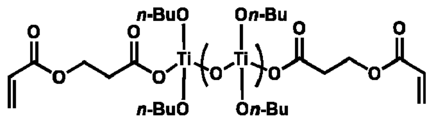 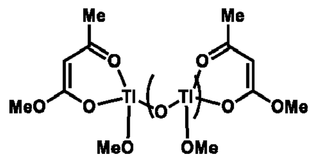

Other non-limiting embodiments of these crosslinking compounds are selected to react with radically-reactive side chains of the copolymer under appropriate conditions. Such crosslinking compounds will have a radically-reactive cross-linking group, including MIRAMER HR-6042 [available from Miwon Specialty Chemical Company]. Examples of such cross-linkers are:

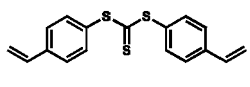 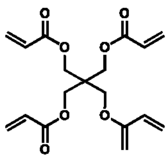 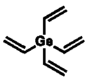 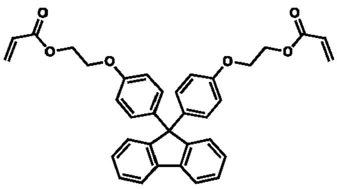 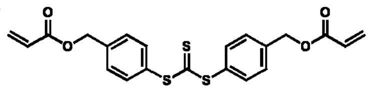

Other non-limiting embodiments of these crosslinking compounds are selected to react with alkene or alkyne side chains of the copolymer under appropriate conditions. Such crosslinking compounds will have an alkene-reactive cross-linking group. Examples of such cross-linkers are:

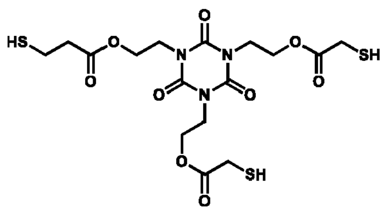 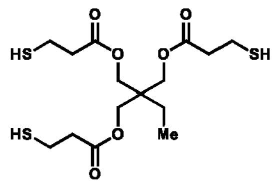 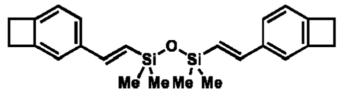

Other non-limiting embodiments of these crosslinking compounds are selected to react with electrophilic side chains of the copolymer under appropriate conditions. Such crosslinking compounds will have a nucleophilic cross-linking group. Examples of such cross-linkers are:

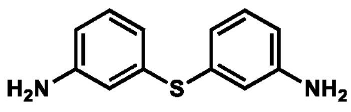 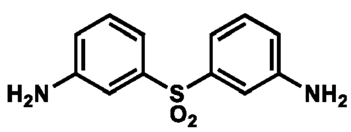 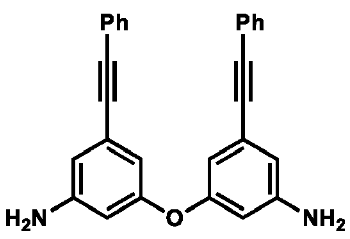 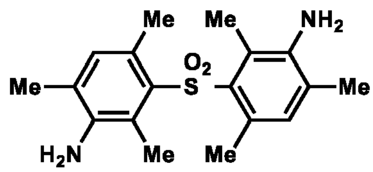 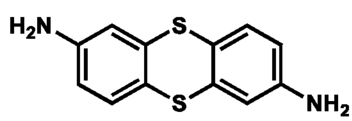

These compounds may be used as an additive or introduced into a copolymer side chain as a pendant group. A crosslinker, if used, is typically present in the formulation in an amount from 0.5 to 50 wt% or from 0.5 to 25 wt% based on total solids of the formulation. In some non-limiting embodiments, the crosslinker is present in the formulation in an amount from 5 to 20 wt% based on total solids.

Depending on the particular copolymer in the formulation, it may be desirable to include a thermal acid generator in the formulation, for example, to allow the curing step to be performed at a lower temperature. Suitable thermal acid generators will depend on the copolymer in the formulation and may be chosen, for example, from

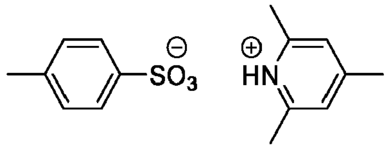

TAG1

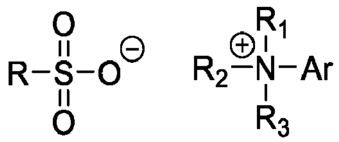

TAG2

where TAG2 is commercially available, for example, from King Industries under the trade name "K-Pure TAG." In some non-limiting embodiments, the thermal acid generator may be selected from the group consisting of CXC-1821 (King Industries), TAG-2689 (King Industries), ammonium triflate, and *N*-benzyl-*N*,*N*-dimethylbenzeneaminium triflate.

A thermal acid generator, if used, is typically present in the formulation in an amount from 0.001 to 25 wt% or from 0.25 to 15 wt% based on total solids of the formulation. In some non-limiting embodiments, the thermal acid generator is present in the formulation in an amount from 0.25 to 2.5 wt%.

Depending on the particular components in the formulation, it may be desirable to include an antioxidant in the formulation, for example, to enhance the stability of the formulation through the reduction of potential oxidative reactions. Suitable antioxidants will depend on the components in the formulation and may be chosen, for example, from pentaerythritol tetrakis(3-(3,5-di-tert-butyl-4-hydroxyphenyl)propionate) [available from BASF under the tradename IRGANOX® 1010], dilauryl thiodipropionate [available from BASF under the tradename IRGANOX® PS800], tris(2,4-di-tert-butylphenyl) phosphite [available from BASF under the tradename IRGAPHOS® 168], poly-(N-Beta-hydroxyethyl-2,2,6,6-tetramethyl-4-hydroxy-piperidyl succinate) thiodipropionate [available from BASF under the tradename Tinuvin® 622], bis(2.4-di-t-butylphenyl) pentaerythritol diphosphate thiodipropionate [available from Brenntag under the tradename ULTRANOX® 626], 40% triethylene glycol bis(3-tert-butyl-4-hydroxy-5-methylphenyl), polyvinyl alcohol and deionized water [available from BASF under the tradename IRGANOX® 245 DW], Weston® 705T, 4-hydroxy-2,2,6,6-tetramethylpiperidin-1-oxyl [also known as 4-hydroxy-TEMPO], tris (trimethylsilyl)silane, trimethylcyclohexyl salicylate, trioctylphosphine, trimethylolpropane tris(3- mercaptopopionate), trimethylolprorpane tris(3-mercaptopropionate), triphenylphosphine, and 3,9-bis(octadecyloxy) 2,4,8,10-tetraoxa-3,9-diphosphaspiro[5,5]undecane and pentaerythritol tetrakis(3 -mercaptopropionate).

An antioxidant, if used, is typically present in the formulation in an amount from 0.1 to 25 wt% or from 0.25 to 15 wt% based on total solids of the formulation. In some non-limiting embodiments, the antioxidant is present in the formulation in an amount from 0.5 to 2.5 wt%.

Depending on the particular components in the formulation, it may be desirable to include a surfactant in the formulation, for example, to reduce the surface tension of the formulation. Suitable surfactants will depend on the components in the formulation and may be chosen, for example, from fluorinated and non-fluorinated surfactants, and may be ionic or non-ionic. In some non-limiting embodiments, the surfactant is chosen from the group consisting of perfluoro-$C_4$ surfactants such as FC-4430 and FC-4432 surfactants [available from 3M Corporation] and fluorodiols such as POLYFOX PF-535, PF-636, PF-6320, PF-656, and PF-6520 fluorosurfactants [available from Omnova] and glycol ethers such as DOWSIL™ FZ-2122 [available from Dow, Inc.].

A surfactant, if used, is typically present in the formulation in an amount from 0.001 to 1 wt% or from 0.01 to 0.5 wt% based on total solids of the formulation. In some non-limiting embodiments, the thermal acid generator is present in the formulation in an amount from 0.05 to 0.25 wt%.

Suitable solvents useful in the preparation of the formulations disclosed herein are generally those that will result in the films prepared therefrom exhibiting uniform film quality when spin-coated at target thicknesses. The solvents are generally organic. Non-limiting embodiments of such solvents include ethers, ketones, esters, alcohols, and aromatic hydrocarbons. In some non-limiting embodiments, the solvent is selected from the group consisting of propylene glycol methyl ether, propylene glycol methyl ether acetate, methyl isobutyl ketone, methyl ethyl ketone, methyl propyl ketone, methyl isoamyl ketone, dimethyl ketone, cyclopentanone, cyclohexanone, gamma-butyrolactone, methyl 2-hydroxyl isobutyrate, ethyl acetate, butyl acetate, methanol, butanol, and the like and combinations thereof. In some non-limiting embodiments, the solvent is selected from the group consisting of methyl isobutyl ketone, methyl ethyl ketone, methyl propyl ketone, methyl isoamyl ketone, dimethyl ketone, cyclopentanone, methyl 2-hydroxyl isobutyrate, and the like and combinations thereof. In some non-limiting embodiments, the formulations disclosed herein comprise one solvent. In some non-limiting embodiments, the formulations disclosed herein comprises two or more solvents. In some non-limiting embodiments, solvents are referred to as additional solvents or cosolvents as would be understood by one having skill in the art.

The present formulations may optionally contain a surface leveling agent, or a "leveling agent." The leveling agent may contain a majority of silicone units derived from the polymerization of the following monomers $Si(R^1)(R^2)(OR^3)_2$ wherein $R^1$, $R^2$ or $R^3$ is each independently chosen from a $C_1$-$C_{20}$ alkyl or a $C_5$-$C_{20}$ aliphatic group or a $C_1$-$C_{20}$ aryl group. In one non-limiting embodiment, the leveling agent is non-ionic and may contain at least two functional groups that can chemically react with functional groups contained in the silicon and non-silicon resins under a cationic photo curing process or thermal curing condition. A leveling agent containing non-reactive groups is present in some non-limiting embodiments. In addition to silicon-derived units the leveling agent may comprise units derived from the polymerization of an $C_3$-$C_{20}$ aliphatic molecule comprising an oxirane ring. In addition, the leveling agent may comprise units derived from an $C_1$-$C_{50}$ aliphatic molecule comprising a hydroxyl group. In some non-limiting embodiments, the leveling agent is free of halogen substituents. In some non-limiting embodiments, the molecular structure of the leveling agent is predominantly linear, branched, or hyperbranched, or it may be a graft structure.

A mixture of leveling agents may be used wherein one or more of the leveling agents comprise silicone-units and one or more leveling agents are free of silicone-units. In some non-limiting embodiments, the leveling agent free of silicone-units may comprise poly ether groups or perfluorinated polyether groups.

The molecular weight of a suitable leveling agent (as determined by GPC using tetrahydrofuran as an eluent and using polystyrene standards for calibration of the molecular weights as detected by refractive index measurements) is varied from 1,000 Da to 1,000,000 Da. In some non-limiting embodiments, the leveling agent may have a mono-modal weight distribution or a multimodal weight distribution.

In one non-limiting embodiment, the leveling agent is as described, for example, in Thin Solid Films 2015, vol. 597, p.212-219. It is commercially available from BYK Additives and Instruments, and has structure:

K. Sakanoue et al. / Thin Solid Films 597 (2015) 212–219

a) BYK322 (Mw. 10,000)

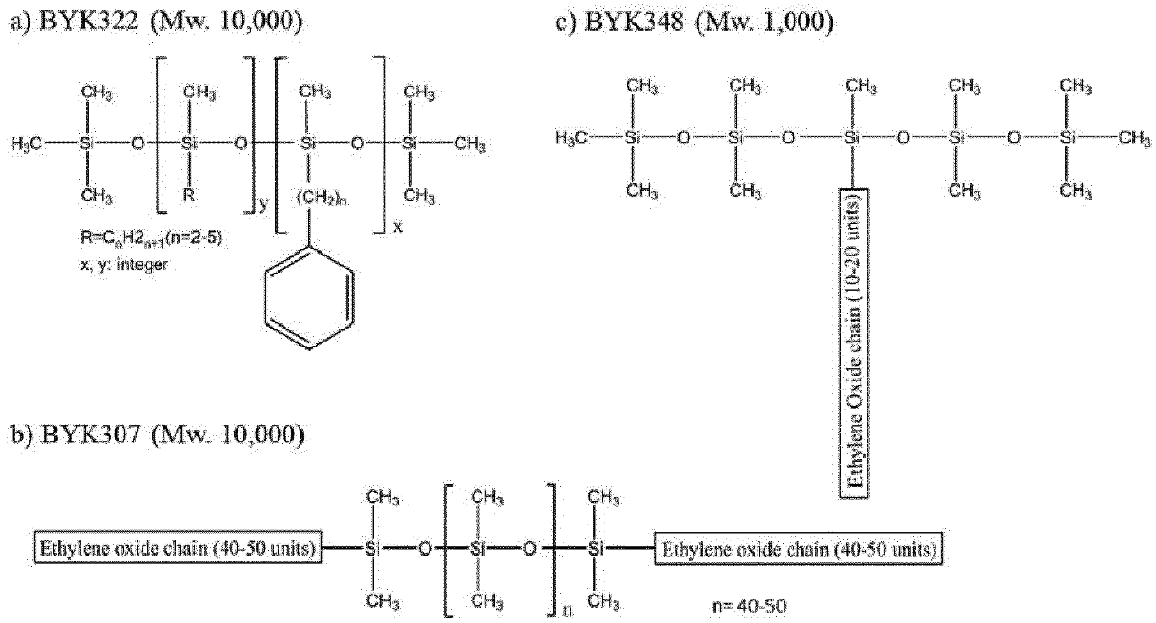

c) BYK348 (Mw. 1,000)

b) BYK307 (Mw. 10,000)

In some non-limiting embodiments; the leveling agent is selected from the group consisting of, AD1700, MD700; Megaface F-114, F-251, F-253, F-281, F-410, F-430, F-477, F-510, F-551, F-552, F-553, F-554, F-555, F-556, F-557, F-558, F-559, F-560, F-561, F-562, F-563, F-565, F-568, F-569, F-570, F-574, F-575, F-576, R-40, R-40-LM, R-41, R-94, RS-56, RS-72-K, RS-75, RS-76-E, RS-76-NS, RS-78, RS-90, DS-21 (DIC Sun Chemical); KY-164, KY-108, KY-1200, KY-1203 (Shin Etsu); Dowsil 14, Dowsil 11, Dowsil 54, Dowsil 57, Dowsil FZ2110, FZ-2123; Xiameter OFX-0077; ECOSURF EH-3, EH-6, EH-9, EH-14, SA-4, SA-7, SA-9, SA-15; Tergitol 15-S-3, 15-S-5, 15-S-7, 15-S-9, 15-S-12, 15-S-15, 15-S-20, 15-S-30, 15-S-40, L61, L-62, L-64, L-81, L-101, XD, XDLW, XH, XJ, TMN-3, TMN-6, TMN-10, TMN-100X, NP-4, NP-6, NP-7, NP-8, NP-9, NP-9.5, NP-10, NP-11, NP-12, NP-13, NP-15, NP-30, NP-40, NP-50, NP-70; Triton CF-10, CF-21, CF-32, CF76, CF87, DF-12, DF-16, DF-20, GR-7M, BG-10, CG-50, CG-110, CG-425, CG-600, CG-650, CA, N-57, X-207, HW 1000, RW-20, RW-50, RW-150, X-15, X-35, X-45, X-114, X-100, X-102, X-165, X-305, X-405, X-705; PT250, PT700, PT3000, P425, P1000TB, P1200, P2000, P4000, 15-200 (Dow Chemical); DC ADDITIVE 3, 7, 11, 14, 28, 29, 54, 56, 57, , 62, 65, 67, 71, 74 , 76, 163 (DowCorning); TEGO Flow 425, Flow 370, Glide 100, Glide 410, Glide 415, Glide 435, Glide 432, Glide 440, Glide 450, Flow 425, Wet 270, Wet 500, Rad 2010, Rad 2200 N, Rad 2011, Rad 2250, Rad 2500, Rad 2700, Dispers 670, Dispers 653, Dispers 656, Airex 962, Airex 990, Airex 936, Airex

910 (Evonik); BYK-300, BYK-301/302, BYK-306, BYK-307, BYK-310, BYK-315, BYK-313, BYK-320, BYK-322, BYK-323, BYK-325, BYK-330, BYK-331, BYK-333, BYK-337, BYK-341, BYK-342, BYK-344, BYK-345/346, BYK-347, BYK-348, BYK-349, BYK-370, BYK-375, BYK-377, BYK-378, BYK-UV3500, BYK-UV3510, BYK-UV3570, BYK-3550, BYK-SILCLEAN 3700, Modaflow 9200, Modaflow 2100, Modaflow Lambda, Modaflow Epsilon, Modaflow Resin, Efka FL, Additiol XL 480, Additol XW 6580, and BYK-SILCLEAN 3720.

The leveling agent can be present in an amount of from 0 to 1 wt%, or from 0.001 to 0.9 wt%, or from 0.05 to 0.5 wt%, or from 0.05 to 0.25 wt%, or from 0.05 to 0.2 wt%, or from 0.1 to 0.15 wt%.

The formulations of the present disclosure may contain one or more photoinitiators in order to render them UV-curable (that is, photocurable), such UV-activated photoinitiators being activated by appropriate UV radiation. A wide variety of photoinitiators may be used. The photoinitiators can comprise acylphosphine oxides, aminoalkylphenones, hydroxylketones, benzil ketals, benzoin ethers, benzophenone, or thioxanthones.

Examples of the photoinitiators can include, but are not limited to, α-hydroxyketones such as 2-hydroxy-2-methyl-1-phenylpropanone (OMNIRAD™ 1173, commercially available from IGM Resins), 1-hydroxycyclohexyl phenyl ketone (OMNIRAD™ 184, commercially available from IGM Resins), 1-[4-(2-hydroxyethyoxyl)-phenyl]-2-hydroxy-2-methyl-1-propanone (OMNIRAD™ 2959, commercially available from IGM Resins); benzophenone; benzoin dimethyl ether; benzyldimethyl-ketal; α-aminoketone; monoacyl phosphines; bisacyl phosphines; phosphine oxides such as diphenyl(2,4,6-trimethylbenzoyl)phosphine oxide, 2, 4, 6-trimethylbenzoyl-diphenyl-phosphine oxide (OMNIRAD™ TPO, commercially available from IGM Resins), OMNIRAD™ 819 (bis(2,4,6-trimethylbenzoyl)-phenylphosphineoxide, IGM Resins), ethyl(3-benzoyl-2,4,6-trimethylbenzol)(phenyl) phosphinate (SPEEDCURE™ XKm, commercially available from Lambson Limited, Wetherby, United Kingdom); diethyoxy-acetophenone (DEAP); and mixtures thereof such as a blend of 2-hydroxy-2-methyl-1-phenylpropanone, bis(2,4,6-trimethylbenzoyl)phenylphosphine oxide and ethyl(2,4,6-trimethylbenzoyl)-phenyl phosphinate (OMNIRAD™ 2022, commercially available from IGM Resins) and a blend of bis(2,4,6-trimethylbenzoyl)phenylphosphine oxide and ethyl(2,4,6-trimethylbenzoyl)-phenyl phosphinate (OMNIRAD™ 2100, commercially available from IGM Resins). The selection of the particular UV wavelength to use for a given photoinitiator, as well as the length of exposure, is well-known to those skilled in the art.

Examples of the photoinitiators can include, but are not limited to oxime ester molecules described by the formula:

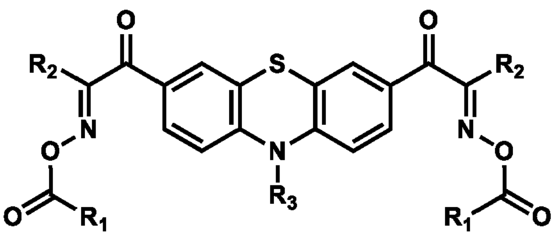

wherein $R_1$ to $R_3$ each are independently hydrogen, halogen, (C1-C20)alkyl, (C6-C20) aryl, (C1-C20)alkoxy, (C6-C20) aryl(C1-C20)alkyl, hydroxy (C1-C20)alkyl, hydroxy (C1-C20)alkoxy (C1-C20)alkyl, or (C3-C20)cycloalkyl. Such molecules include SPI-05, commercially available from Samyang Corporation.

The photoinitiator can be present in an amount of from 0 to 1 wt%, or from 0.001 to 0.9 wt%, or from 0.05 to 0.5 wt%, or from 0.05 to 0.25 wt%, or from 0.05 to 0.2 wt%, or from 0.1 to 0.15 wt%.

The formulations of the present disclosure may further comprise a photoacid generator (PAG). Suitable PAGs can generate an acid that, during post-exposure bake, causes cleavage of acid-labile groups present on a polymer of the photoresist composition. Suitable PAG compounds are known in the art of chemically amplified photoresists and may be ionic or nonionic. Suitable PAG compounds include, for example: onium salts, for example, triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate; di-t-butyphenyliodonium perfluorobutanesulfonate, and di-t-butyphenyliodonium camphorsulfonate. Non-ionic sulfonates and sulfonyl compounds are also known to function as photoacid generators, e.g., nitrobenzyl derivatives, for example, 2-nitrobenzyl-p-toluenesulfonate, 2,6-dinitrobenzyl-p-toluenesulfonate, and 2,4-dinitrobenzyl-p-toluenesulfonate; sulfonic acid esters, for example, 1,2,3-tris(methanesulfonyloxy)benzene, 1,2,3-tris(trifluoromethanesulfonyloxy)benzene, and 1,2,3 -tris(p-toluenesulfonyloxy)benzene; diazomethane derivatives, for example, bis(benzenesulfonyl)diazomethane, bis(p-toluenesulfonyl)diazomethane; glyoxime derivatives, for example, bis-O-(p-toluenesulfonyl)-α-dimethylglyoxime, and bis-O-(n-butanesulfonyl)-α-dimethylglyoxime; sulfonic acid ester derivatives of an N-hydroxyimide compound, for example, N-hydroxysuccinimide methanesulfonic acid ester, N-hydroxysuccinimide trifluoromethanesulfonic acid ester; and halogen-containing triazine compounds, for example, 2-(4-methoxyphenyl)-4,6-bis(trichloromethyl)-1,3,5-triazine, and 2-(4-methoxynaphthyl)-4,6-bis(trichloromethyl)-1,3,5-triazine. Suitable photoacid generators are further described in U.S. Patent No. 8,431,325 to Hashimoto et al. in column 37, lines 11-47 and columns 41-91. Other suitable sulfonate PAGs include

sulfonated esters and sulfonyloxy ketones, nitrobenzyl esters, s-triazine derivatives, benzoin tosylate, t-butylphenyl α-(p-toluenesulfonyloxy)-acetate, and t-butyl α-(p-toluenesulfonyloxy)-acetate; as described in U.S. Patent Nos. 4,189,323 and 8,431,325.

In some non-limiting embodiments, suitable PAGs have formula $G^+A^-$, wherein $G^+$ is an organic cation and $A^-$ is an organic anion. Organic cations include, for example, iodonium cations substituted with two alkyl groups, aryl groups, or a combination of alkyl and aryl groups; and sulfonium cations substituted with three alkyl groups, aryl groups, or a combination of alkyl and aryl groups. In some embodiments, $G^+$ is an iodonium cation substituted with two alkyl groups, aryl groups, or a combination of alkyl and aryl groups; or a sulfonium cation substituted with three alkyl groups, aryl groups, or a combination of alkyl and aryl groups. In some embodiments, $G^+$ may be one or more of a substituted sulfonium cation having the formula (3A) or an iodonium cation having the formula (3B):

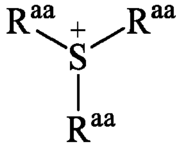

(3A)

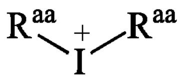

(3B)

wherein, each $R^{aa}$ is independently a $C_{1-20}$ alkyl group, a $C_{1-20}$ fluoroalkyl group, a $C_{3-20}$ cycloalkyl group, a $C_{3-20}$ fluorocycloalkyl group, a $C_{2-20}$ alkenyl group, a $C_{2-20}$ fluoroalkenyl group, a $C_{6-30}$ aryl group, a $C_{6-30}$ fluoroaryl group, $C_{6-30}$ iodoaryl group, a $C_{4-30}$ heteroaryl group, a $C_{7-20}$ arylalkyl group, a $C_{7-20}$ fluoroarylalkyl group, a $C_{5-30}$ heteroarylalkyl group, or a $C_{5-30}$ fluoroheteroarylalkyl group, each of which is substituted or unsubstituted, wherein each $R^{aa}$ is either separate or connected to another group $R^{aa}$ via a single bond or a divalent linking group to form a ring. Each $R^{aa}$ optionally may include as part of its structure one or more groups selected from -O-, -C(O)-, - C(O)-O-, -$C_{1-12}$ hydrocarbylene-, -O-($C_{1-12}$ hydrocarbylene)-, -C(O)-O-($C_{1-12}$ hydrocarbylene)-, and -C(O)-O-($C_{1-12}$ hydrocarbylene)-O-. Each $R^{aa}$ independently may optionally comprise an acid-labile group chosen, for example, from tertiary alkyl ester groups, secondary or tertiary aryl ester groups, secondary or tertiary ester groups having a combination of alkyl and aryl groups, tertiary alkoxy groups, acetal groups, or ketal groups. Suitable divalent linking groups for connection of $R^{aa}$ groups include, for example, -O-, -S-, -Te-, -Se-, -C(O)-, -C(S)-, -C(Te)-, or -C(Se)-, substituted or unsubstituted $C_{1-5}$ alkylene, and combinations thereof.

Exemplary sulfonium cations of formula (3A) include the following:

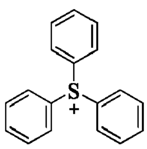
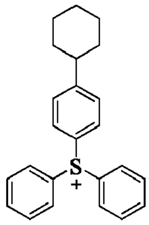
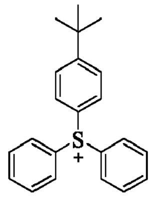
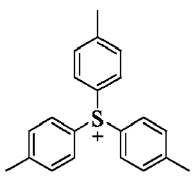
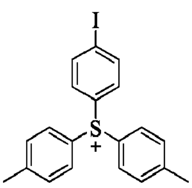
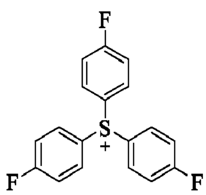
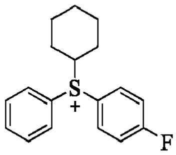
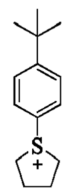
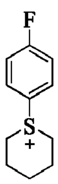
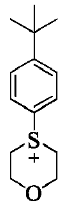
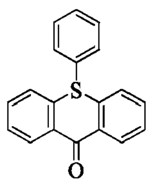
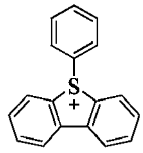
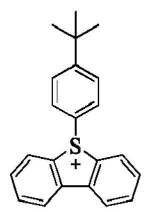

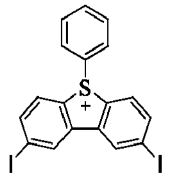 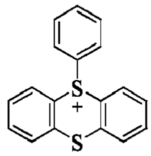 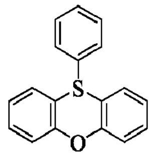 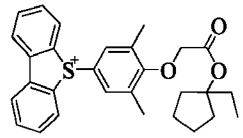

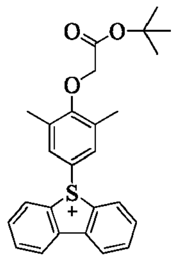 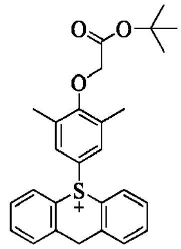 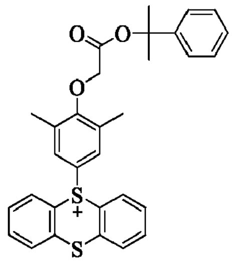 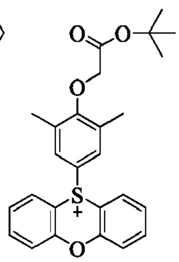

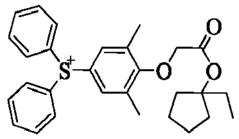 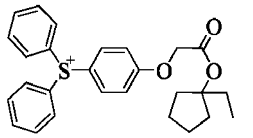 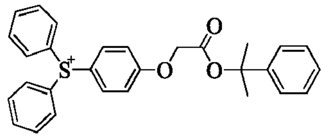

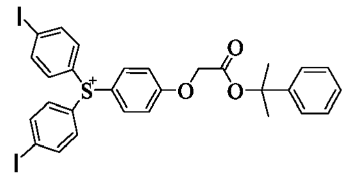 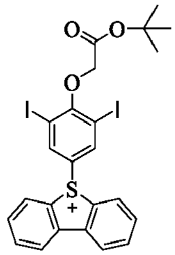 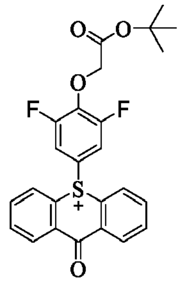

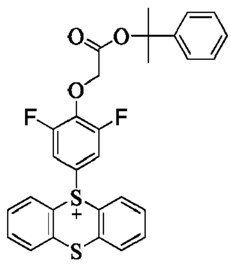 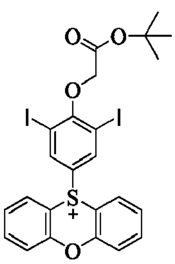 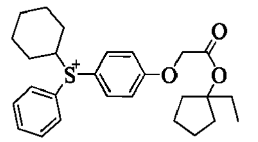

Exemplary iodonium cations of formula (3B) include the following:

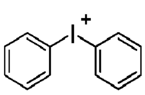 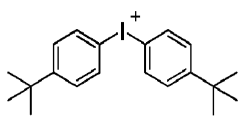 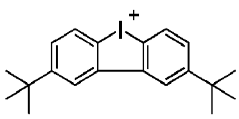 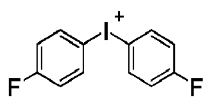

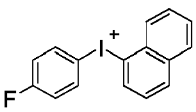 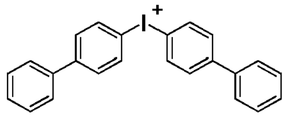 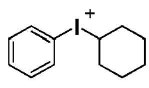 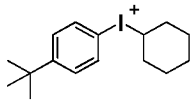

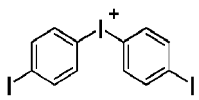 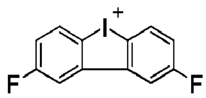 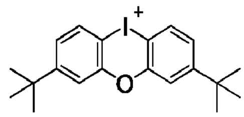 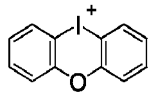

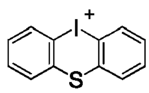 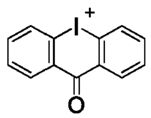 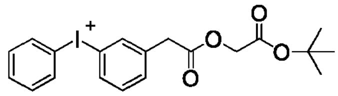

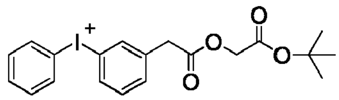 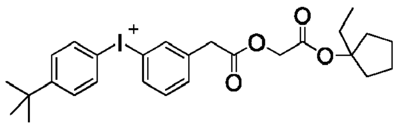

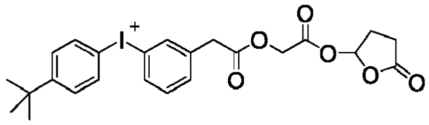

PAGs that are onium salts typically comprise an anion having a sulfonate group or a non-sulfonate type group, such as a sulfonamidate group, a sulfonimidate group, a methide group, or a borate group. Exemplary suitable anions having a sulfonate group include the following:

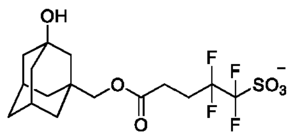 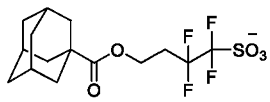 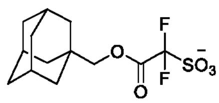 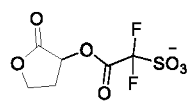

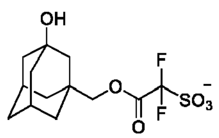 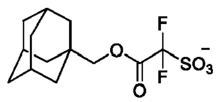 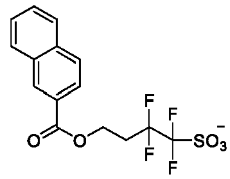 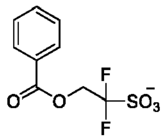 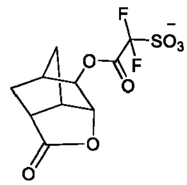

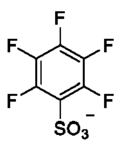 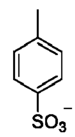 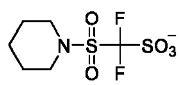 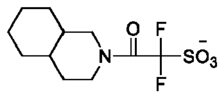 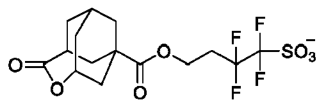

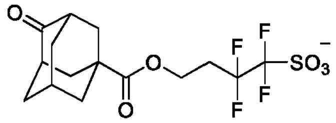 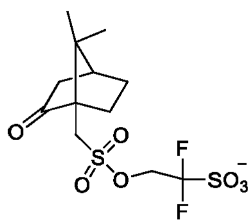 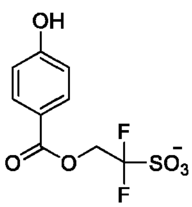 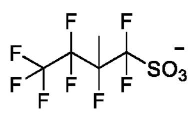

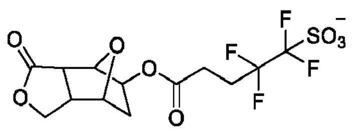 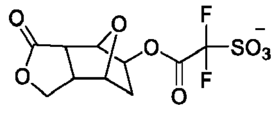 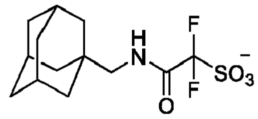 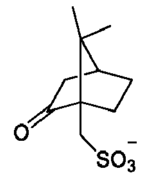

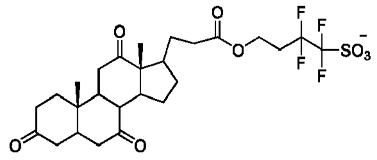 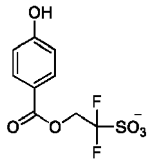 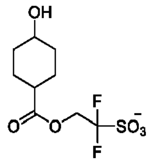 .

Exemplary suitable non-sulfonated anions include the following:

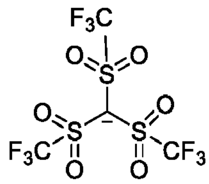 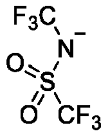 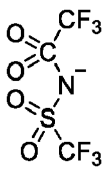 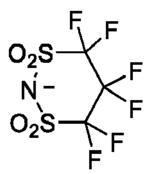 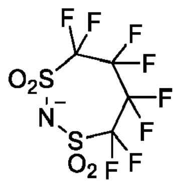

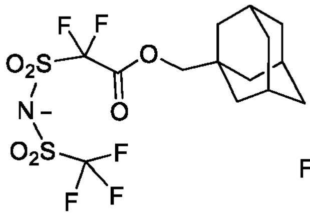 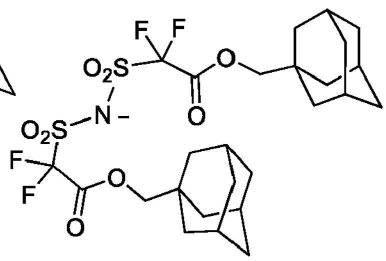 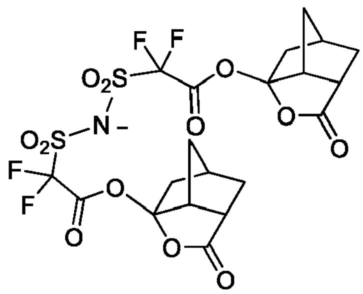

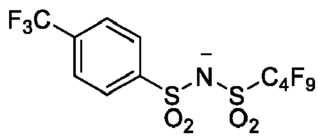 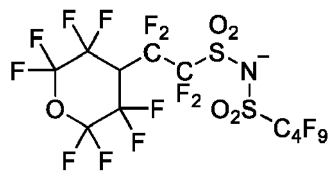 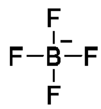 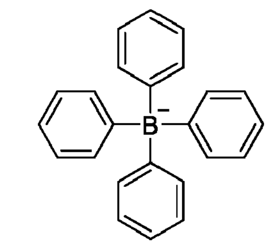 .

The formulations of the present disclosure may optionally contain one or more oxygen scavengers in sufficient amounts to maintain oxygen content of the formulation at 1000 ppb or less. In some non-limiting embodiments, the oxygen content of the formulation is 1000 ppb to 0 ppb, in some non-limiting embodiments 500 ppb to 0 ppb, in some non-limiting embodiments 200 ppb to 0 ppb.

Oxygen scavengers include, but are not limited to, hydroxyl amine compounds having a formula:

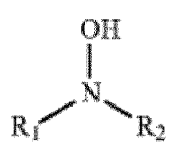

wherein $R_1$ and $R_2$ may be the same or different and are hydrogen, substituted or unsubstituted $(C_1-C_{10})$alkyl, substituted or unsubstituted $(C_5-C_{10})$cycloalkyl or substituted or unsubstituted $(C_6-C_{10})$aryl, with the proviso that $R_1$ and $R_2$ are not hydrogen at the same time. Non-limiting examples of such alkyl groups include methyl, ethyl, propyl, isopropyl, hydroxymethyl, 2-hydroxyethyl, pentyl, t-butyl and octyl. Non-limiting examples of cycloalkyl groups include cyclopentyl, cyclophexyl, 4-methy-lcyclohexyl and cyclooctyl. Non-limiting examples of aryl groups include phenyl, naphthayl, xylyl, 4-hydroxyphenyl and tolyl. Non-limiting examples of specific oxygen scavengers include N-methylhydroxylamine, N-isopropylhydroxylamine, N-cyclohexylhydroxylamine and N,N-diethylhydroxylamine.

Oxygen scavengers may also include, but are not limited to, organic acids such as aliphatic, aromatic and amino carboxylic acids and salts thereof. Non-limiting examples of carboxylic acids include acetic acid, propionic acid, butyric acid, pentanoic acid, 3-methylbutanoic acid, gallic acid, citric acid, lactic acid, ascorbic acid, tartronic acid and 2,4-dihydroxybenzoic acid. Non-limiting examples of amino carboxylic acids include glycine, dihydroxy ethyl glycine, alanine, valine, leucine, asparagines, glutamine and lysine.

Additional oxygen scavengers may also include hydrazine, carbohydrazide, erythorbate, methylethylketoxime, hydroquinone, hydroquinone sulfonate, sodium salt, ethoxyquin, methyltetrazone, tetramethylphenylenediamine, DEAE 2-ketogluconate Tinuvin® 123 and 292 (BASF), and hydroxy acetone. In some non-limiting embodiments, oxygen scavengers are selected from the group consisting of hydroquinone and hydroquinone sulfonate, sodium salt.

In general, when present, oxygen scavengers are included in the formulations in amounts of 0.001 wt % to 1 wt %. In some non-limiting embodiments the oxygen scavengers are included in the solutions in amounts of 0.005 wt % to 0.1 wt % to provide the desired oxygen content of the formulation.

The formulations of the present disclosure may optionally contain one or more UV blockers. Non-limiting examples of UV blockers include anthraquinone, substituted anthraquinones such as alkyl and halogen substituted anthraquinones such as 2-tertiary butyl anthraquinone, 1-chloroanthraquinone, p-chloroanthraquinone, 2-methylanthraquinone, 2-ethylanthraquinone, octamethyl anthraquinone and 2-amylanthraquinone, optionally substituted polynuclear quinones such as 1,4-naphthaquinone, 9,10-phenanthraquinone, 1,2-benzanthraquinone, 2,3-benzanthraquinone, 2-methyl-1,4-napththoquinone, 2,3-dichloronaphthaquinone, 1,4-dimethylanthraquinone, 2,3-dimethylanthraquinone, 2-phenylanthraquinone, 2,3-diphenylanthraquinone, 3 -chloro-2-methylanthraquinone, retenequinone, 7,8,9,10-tetrahydronaphthaanthraquinone, 1,2,3,4-tetrahydrobenzanthracene-7,2-dione, acetophenones such as acetaphenone, 2,2-dimethoxy-2-phenyl acetophenone, 2,2-diethoxy-2-phenyl acetophenone, 1,1-dichloro acetophenone, 1-hydroxy cyclohexyl phenylketone and 2-methyl-1-(4-methylthio)phenyl-2-morpholin-propan-1-one; thioxanthones such as 2-methylthioxanthone, 2-decylthioxanthone, 2-dodecylthioxanthone, 2-isopropylthioxanthone, 2,4-dimethylthioxanthone, 2,4-diethylthioxanthone, 2-chlorothioxanthone and 2,4-diisopropylthioxanthone; ketals such as acetophenone dimethylketal and dibenzylketal; benzoins and benzoin alkyl ethers such as benzoin, benzylbenzoin methyl ether, benzoin isopropyl ether and benzoin isobutyl ether; azo compounds such as azobisisovaleronitrile; Michler's Ketone, Ethyl Michler's Ketone and xanthone, and mixtures thereof.

Organic pigments may also be used as UV blockers. Such organic pigments include, but are not limited to: carbon black, indigo, phthalocyanine, para red, flavanoids such as red, yellow, blue, orange and ivory colors. Specific organic pigments having Color Index (C.I.) numbers include C.I. Pigment Yellow 12, C.I. Pigment Yellow 13, C.I. Pigment yellow 14, C.I. Pigment Yellow 17, C.I. Pigment Yellow 20, C.I. Pigment Yellow 24, C.I. Pigment Yellow 31, C.I. Pigment Yellow 55, C.I. Pigment Yellow 83, C.I. Pigment Yellow 93, C.I. Pigment yellow 109, C.I. Pigment Yellow 110, C.I. Pigment Yellow 139, C.I. Pigment Yellow 153, C.I. Pigment Yellow 154, C.I. Pigment Yellow 166, C.I. Pigment Yellow 168, C.I. Pigment Orange 36, C.I. Pigment Orange 43, C.I. Pigment Orange 51, C.I. Pigment Red 9, C.I. Pigment Red 97, C.I. Pigment Red 122, C.I. Pigment Red 123, C.I. Pigment Red 149, C.I. Pigment Red 176, C.I. Pigment Red 177, C.I. Pigment Red 180, C.I. Pigment Red 215, C.I. Pigment Violet 19, C.I. Pigment Violet 23, C.I. Pigment Violet 29, C.I. Pigment Blue 15, C.I. Pigment Blue 15:3, C.I. Pigment Blue 15:6, C.I. Pigment Green 7, C.I. Pigment Green 36, C.I. Pigment Brown 23, C.I. Pigment Brown 25, C.I. Pigment Black 1 and C.I. Pigment Black 7. Other suitable pigments include, but are not limited to: titanium dioxide, Prussian blue, cadmium sulfide, iron oxides, vermillion, ultramarine and the chrome pigments, including chromates, molybdates and mixed chromates and sulfates of lead, zinc, barium, calcium and mixtures and modifications thereof which are commercially available as greenish-yellow to red pigments under the names primrose, lemon, middle orange, scarlet and red chromes.

Organic dyes also may be used as UV blockers. Such dyes include, but are not limited to: azo dyes, anthraquinone, benzodifuranone, indigold, polymethine and related dyes, styryl, di- and triaryl carbonium dyes and related dyes, quinophthalones, sulfurbased dyes, nitro and nitroso dyes, stilbenes, formazans, dioxazines, perylenes, quinacridones, pyrrolo-pyrroles, isoindolines and isoindolinones. Other suitable dyes include, but are not limited to: azo dyes, metal complex dyes, naphthol dyes, indigo dyes, carbonium dyes, quinoneimine dyes, xanthene dyes, cyanine dyes, quinoline dyes, nitro dyes, nitroso dyes, benzoquinone dyes, naphthoquinone dyes, penoline dyes, pthalicyanine dyes, leuco dyes and fluorescent dyes. Examples of fluorescent dyes are xanthenes such as rhodamine and fluorescein, bimanes, coumarins such as umbelliferone, aromatic amines such as dansyl, squarate dyes, benzofurans, cyanines, merocyanines, rare earth chelates and carbozoles.

Commercially-available UV blockers include, but are not limited to: CYASORB™ UV 24 available from Spectrum laboratories Inc., LOWILITE™ 27, LOWILITE™ 22, LOWILITE™ 55, LOWILITE™ 26 available from Addivant LLC, BLS 531, BLS 5411, BLS 1326 available from Mayzo, Inc., Speedcure™ ITX, EHA and 3040, Irgacure™ 184, 369, 907 and

1850, Daracure™ 1173 Uvinul® 3027, 3028, 3029, 3030, 3033, and 3035, as well as Tinuvin® 460, 479, and 1600 available from BASF. Speedcure™, Irgacure™ and Daracure™ are registered trademarks of Lambson Plc and Ciba GmbH, respectively.

In general, when present, UV blockers are included in the formulations in amounts of 0.001 wt % to 1 wt %. In some non-limiting embodiments the UV blockers are included in the solutions in amounts of 0.005 wt % to 0.1 wt % to provide the desired level of UV protection.

The formulations of the present disclosure may optionally contain one or more hindered-amine light stabilizers. The hindered amine or hindered amine derivative is a generic term for a compound that has an organic or inorganic bulky structure directly attached to at least one place of three joint places of the nitrogen atom showing an amine structure. More specifically, the structure of the secondary or tertiary amine known as a hindered amine light stabilizer (HALS) is included, for example, a structure (such as TEMPO, 4-hydroxy-TEMPO) wherein one position of the nitrogen atom is substituted with an oxy radical is well known.

In general, when present, hindered-amine light stabilizers are included in the formulations in amounts of 0.001 wt % to 1 wt %. In some non-limiting embodiments the hindered-amine light stabilizers are included in the solutions in amounts of 0.005 wt % to 0.1 wt % to provide the desired level of stability.

In some non-limiting embodiments of the formulation disclosed herein, the weight percentage of the copolymer comprising one or more high refractive index first monomers and one or more second monomers comprising a reactive side chain is between 5% and 95%, in some non-limiting embodiments between 10% and 80%, in some non-limiting embodiments between 15% and 75%, in some non-limiting embodiments between 20% and 60%, and in some non-limiting embodiments between 25% and 50%.

In some non-limiting embodiments of the formulation disclosed herein, the composition optionally comprises the copolymer comprising one or more high refractive index first monomers and one or more second monomers comprising a reactive side chain and one or more additional polymers or copolymers. In such formulations, the mass ratio of the first copolymer and any additional second polymers or copolymers is between 99:1 and 1:99, in some non-limiting embodiments between 80:20 and 20:80, in some non-limiting embodiments between 60:40 and 40:60.

In some non-limiting embodiments of the formulation disclosed herein, the composition optionally comprises the copolymer comprising one or more high refractive index first monomers and one or more second monomers comprising a reactive side chain and one or more additional polymers or copolymers. In such formulations, the weight percentage of the combined polymers and copolymers is between 5% and 95%, in some non-limiting embodiments between 10% and 80%, in some non-limiting embodiments between 15% and 75%, in some non-limiting embodiments between 20% and 60%, and in some non-limiting embodiments between 25% and 50%.

In some non-limiting embodiments of the formulation disclosed herein, the weight percentage of the crosslinker is between 0.1% and 50%, in some non-limiting embodiments between 0.5% and 40%, in some non-limiting embodiments between 1% and 30%, in some non-limiting embodiments between 1% and 25%, and in some non-limiting embodiments between 1% and 20%.

In some non-limiting embodiments of the formulation disclosed herein, the weight percentage of the thermal acid generator is between 0.01% and 10%, in some non-limiting embodiments between 0.05% and 5%, in some non-limiting embodiments between 0.07% and 3%, in some non-limiting embodiments between 0.08% and 2.5%, and in some non-limiting embodiments between 0.1% and 2.0%.

In some non-limiting embodiments of the formulation disclosed herein, the weight percentage of the antioxidant is between 0.01% and 20%, in some non-limiting embodiments between 0.05% and 15%, in some non-limiting embodiments between 0.07% and 10%, in some non-limiting embodiments between 0.08% and 7.5%, and in some non-limiting embodiments between 0.1% and 5.0%.

In some non-limiting embodiments of the formulation disclosed herein, the weight percentage of the surfactant is between 0.0001% and 10%, in some non-limiting embodiments between 0.0005% and 5%, in some non-limiting embodiments between 0.0007% and 2.5%, in some non-limiting embodiments between 0.0008% and 1.5%, and in some non-limiting embodiments between 0.001% and 1%.

In some non-limiting embodiments of the formulation disclosed herein, the weight percentage of the solvent is between 10% and 90%, in some non-limiting embodiments between 15% and 85%, in some non-limiting embodiments between 20% and 80%, in some non-limiting embodiments between 25% and 77%, and in some non-limiting embodiments between 30% and 75%.

In some non-limiting embodiments of the formulation disclosed herein, the weight percentage of the one or more components selected from the group consisting of surface leveling agents, photoinitiators, photoacid generators, oxygen scavengers, UV blockers, and hindered-amine light scavengers is between 0.0001% and 20%, in some non-limiting embodiments between 0.0005% and 15%, in some non-limiting embodiments between 0.0007% and 10%, in some non-limiting embodiments between 0.0008% and 7%, and in some non-limiting embodiments between 0.001% and 5%.

The present disclosure is further directed to a method for forming an optical thin film comprising a copolymer

comprising one or more high refractive index first monomers and one or more second monomers comprising a reactive side chain wherein the process comprises the following steps in order: spin coating a formulation comprising (a) a copolymer comprising one or more high refractive index first monomers and one or more second monomers comprising a reactive side chain; (b) a crosslinker; (c) a thermal acid generator; (d) an antioxidant; (e) a surfactant; and (f) a solvent onto a substrate; soft-baking the coated substrate; and treating the soft-baked coated substrate at one or more pre-selected temperatures for one or more pre-selected time intervals.

Non-limiting, specific method embodiments for the copolymer comprising one or more high refractive index first monomers, the one or more second monomers comprising a reactive side chain, and the formulation comprising (a) a copolymer comprising one or more high refractive index first monomers and one or more second monomers comprising a reactive side chain; (b) a crosslinker; (c) a thermal acid generator; (d) an antioxidant; (e) a surfactant; and (f) a solvent are the same as those disclosed herein in the context of the copolymer composition and the formulation.

Spin coating is a non-limiting example of coating processes known to those with skill in the art. Other non-limiting processes include dipping, drop-casting, roller-coating, screen printing, ink-jet printing, gravure, slot-die coating, or other conventional coating techniques. In the electronics manufacturing industry, spin-coating and slot-die coating are preferred methods to take advantage of existing equipment and processes. In spin-coating, the solids content of the composition may be adjusted, along with the spin speed, to achieve a desired thickness of the formulation on the surface to which it is applied. Typically, the present formulations are spin-coated at a spin speed of 400 to 4000 rpm. The amount of the formulation dispensed on the substrate depends on the total solids content in the composition, the desired thickness of the resulting coating layer, and other factors well-known to those skilled in the art.

Substrates onto which the materials may be coated are those generally used in the art. In some non-limiting embodiments, the substrates used are selected from the group consisting of silica, Si wafers, silicon nitride, silicon oxynitride, silicon carbide, silicon-germanium, gallium-arsenide, indium-phosphide, indium-tin-oxide, aluminum nitride, alumina, glass, and the like. In some non-limiting embodiments, the substrates used are selected from the group consisting of silica, Si wafers, silicon nitride, and silicon carbide. In some non-limiting embodiments, the substrate used is Si wafers. In some non-limiting embodiments, the substrate used is glass. In some non-limiting embodiments, the substrate used comprises a polymer film or a polymer composite film akin to those generally used in the art. In some non-limiting embodiments, the substrate used comprises multiple materials, including those specified above, disposed in layers or patterns that vary in composition.

The thickness of the formulation and / or optical thin film is not particularly limited and will depend, for example, on the particular application or use. In some non-limiting embodiments, the thickness of the coating and / or optical thin film is between 50 nm and 100 μm. In some non-limiting embodiments, the thickness of the coating and / or optical thin film is between 100 nm and 50 μm. In some non-limiting embodiments, the thickness of the coating and / or optical thin film is between 500 nm and 20 μm. In some non-limiting embodiments, the thickness of the coating and / or optical thin film is between 1 μm and 10 μm. In some non-limiting embodiments, the thickness of the coating and / or optical thin film is 1 μm, in some non-limiting embodiments 2 μm, in some non-limiting embodiments 3 μm, in some non-limiting embodiments 4 μm, in some non-limiting embodiments5 μm, in some non-limiting embodiments 6 μm, in some non-limiting embodiments 7 μm, in some non-limiting embodiments 8 μm, in some non-limiting embodiments 9 μm, and in some non-limiting embodiments 10 μm.

In some non-limiting embodiments, after being coated on a substrate surface, the formulation is soft-baked (heated) to remove any organic solvent present. Typical soft-baking temperatures are from 90 °C to 140 °C, although other suitable temperatures may be used. In some non-limiting embodiments of the present disclosure, the soft-baking is performed at temperatures between 90 °C and 130 °C, in some non-limiting embodiments between 90 °C and 120 °C, in some non-limiting embodiments between 90 °C and 110 °C, and in some non-limiting embodiments between 90 °C and 100 °C. In some non-limiting embodiments; the soft-baking is performed at 90 °C, in some non-limiting embodiments 100 °C, in some non-limiting embodiments 110 °C, in some non-limiting embodiments 120 °C, in some non-limiting embodiments 130 °C, and in some non-limiting embodiments 140 °C. Soft-baking is generally done for approximately 30 sec. to 2 min., although longer or shorter times may suitably be used. In some non-limiting embodiments, soft-baking is done for 30 sec., in some non-limiting embodiments 45 sec., in some non-limiting embodiments 1 min., in some non-limiting embodiments 1 min. 15 sec., in some non-limiting embodiments 1 min. 30 sec., in some non-limiting embodiments 1 min. 45 sec., and in some non-limiting embodiments 2 min. In some non-limiting embodiments, soft-baking is done for 15 sec., and in some non-limiting embodiments soft-baking may be done for 3 minutes or more. Following solvent removal, a film of the copolymer on the substrate surface is obtained.

After the soft-bake step, the coating layer, film, or coating is typically cured at elevated temperature to remove substantially all of the solvent from the polymeric layer, thereby forming a tack-free coating and improving adhesion of the layer to the underlying structure. Depending on the particular copolymer and components of the composition, the cure may cause further change to the polymer, for example, through one or more of oxidation, outgassing, polymerization, condensation, or cross-linking. The cure is typically conducted on a hotplate or in an oven. The cure can be conducted, for example, in an atmosphere of air or inert gas such as nitrogen, argon or helium, or can be conducted under vacuum.

In one non-limiting embodiment, the polymeric layer is cured in an inert gas atmosphere. In one non-limiting embodiment, the polymeric layer is cured under ambient atmospheric conditions. The temperature and time for the cure will depend, for example, on the particular copolymer and solvent of the formulation, and the layer thickness. In some non-limiting embodiments, cure temperatures are from 100 °C to 450 °C. In some non-limiting embodiments, cure temperatures are 300 °C to 400 °C, or from 325 °C to 350 °C. In coatings wherein the polymeric layer comprises a crosslinker and/or a thermal acid generator, lower cure temperatures can sometimes be used. In some non-limiting embodiments, these lower cure temperatures are from 50 °C to 250 °C. In some non-limiting embodiments, these lower cure temperatures are from 150 °C to 200 °C. In one non-limiting embodiment, wherein the polymeric layer comprises a crosslinker and a thermal acid generator, the cure temperature is 200 °C. In some non-limiting embodiments, the cure time is from 30 seconds to two hours. In one non-limiting embodiment, the cure time is 5 minutes. In some non-limiting embodiments, the cure time is from 10 minutes to 60 minutes. In one non-limiting embodiment, the cure time is 30 minutes. The cure can be conducted in a single step or in multiple steps. The cure can be conducted by heating the copolymer formulation layer at constant temperature or with a varied temperature profile such as a ramped or terraced temperature profile. The temperatures and times associated with the ramped or terraced temperature profile are generally preselected based on the specific formulation composition and intended end use of the associated layer, film, or coating that results from the method.

The present disclosure is further directed to an optical thin film comprising a copolymer comprising one or more high refractive index first monomers and one or more second monomers comprising a reactive side chain. In some non-limiting embodiments, the optical thin film has a thickness between 10 nm and 100 μm. In some non-limiting embodiments, the optical thin film as a thickness between 100 nm and 50 μm, in some non-limiting embodiments between 500 nm and 25 μm, in some non-limiting embodiments between 750 nm and 15 μm, in some non-limiting embodiments between 0.01 μm and 12 μm, in some non-limiting embodiments between 0.1 μm and 10 μm, and in some non-limiting embodiments between 1 μm and 5 μm.

In some non-limiting embodiments, the optical thin films of the present disclosure have a refractive index measured at 550 nm that is greater than 1.50 and in some non-limiting embodiments greater than 1.55. In some non-limiting embodiments, the optical thin films of the present disclosure have a refractive index measured at 550 nm that is greater than 1.60, in some non-limiting embodiments greater than 1.65, in some non-limiting embodiments greater than 1.66, in some non-limiting embodiments greater than 1.67, in some non-limiting embodiments greater than 1.68, in some non-limiting embodiments greater than 1.69, in some non-limiting embodiments greater than 1.70, in some non-limiting embodiments greater than 1.71, in some non-limiting embodiments greater than 1.72, in some non-limiting embodiments greater than 1.73, in some non-limiting embodiments greater than 1.74, in some non-limiting embodiments greater than 1.75, in some non-limiting embodiments greater than 1.76, in some non-limiting embodiments greater than 1.77, in some non-limiting embodiments greater than 1.78, and in some non-limiting embodiments greater than 1.79. In some non-limiting embodiments, the coatings and /or optical thin films of the present disclosure have a refractive index measured at 550 nm that is greater than 1.80.

In some non-limiting embodiments, the optical thin films of the present disclosure have a refractive index measured at other wavelengths of the visible spectrum. In some non-limiting embodiments, the optical thin films of the present disclosure have a refractive index measured between 380 nm and 1400 nm. In some non-limiting embodiments, the optical thin films of the present disclosure have a refractive index measured between 400 nm and 700 nm. In some non-limiting embodiments, the optical thin films of the present disclosure have a refractive index measured between 450 nm and 650 nm. In some non-limiting embodiments, the optical thin films of the present disclosure have a refractive index measured between 500 nm and 600 nm.

In some non-limiting embodiments, the optical thin films of the present disclosure have a refractive index measured at these other wavelengths of the visible spectrum that is greater than 1.50. In some non-limiting embodiments, the optical thin films of the present disclosure have a refractive index measured at these other wavelengths of the visible spectrum that is greater than 1.60. In some non-limiting embodiments, the optical thin films of the present disclosure have a refractive index measured at these other wavelengths of the visible spectrum that is greater than 1.65. In some non-limiting embodiments, the optical thin films of the present disclosure have a refractive index measured at these other wavelengths of the visible spectrum that is greater than 1.67. In some non-limiting embodiments, the optical thin films of the present disclosure have a refractive index measured at these other wavelengths of the visible spectrum that is greater than 1.70. In some non-limiting embodiments, the optical thin films of the present disclosure have a refractive index measured at these other wavelengths of the visible spectrum that is greater than 1.80.

In some non-limiting embodiments, the optical thin films of the present disclosure have a percent transmittance greater than or equal to 75% at wavelengths between 400 nm and 1000 nm, in some non-limiting embodiments greater than or equal to 80% at wavelengths between 400 nm and 1000 nm, in some non-limiting embodiments greater than or equal to 85% at wavelengths between 400 nm and 1000 nm, in some non-limiting embodiments greater than or equal to 90% at wavelengths between 400 nm and 1000 nm, in some non-limiting embodiments greater than or equal to 95% at wavelengths between 400 nm and 1000 nm, and in some non-limiting embodiments greater than or equal to 99% at

wavelengths between 400 nm and 1000 nm.

There are a number of reliability parameters associated with the optical thin films disclosed herein which make them useful in a variety of optical and electronic applications. The reliability-in-use is generally assessed by the stability of the optical thin film refractive index and / or percent transmission at wavelengths between 400 nm and 1000 nm when the optical thin films are exposed to a variety of environmental stressors. In some non-limiting embodiments of the optical thin films disclosed herein, the refractive index of the optical thin film at 550 nm changes by less than or equal to 15% when exposed to one or more environmental stressors, in some non-limiting embodiments the refractive index of the optical thin film at 550 nm changes by less than or equal to 10% when exposed to one or more environmental stressors, in some non-limiting embodiments the refractive index of the optical thin film at 550 nm changes by less than or equal to 5% when exposed to one or more environmental stressors, in some non-limiting embodiments the refractive index of the optical thin film at 550 nm changes by less than or equal to 4% when exposed to one or more environmental stressors, in some non-limiting embodiments the refractive index of the optical thin film at 550 nm changes by less than or equal to 3% when exposed to one or more environmental stressors, in some non-limiting embodiments the refractive index of the optical thin film at 550 nm changes by less than or equal to 2% when exposed to one or more environmental stressors, and in some non-limiting embodiments the refractive index of the optical thin film at 550 nm changes by less than or equal to 1% when exposed to one or more environmental stressors.

In some non-limiting embodiments of the optical thin films disclosed herein, the percent transmission at wavelengths between 400 nm and 1000 nm of the optical thin film at 550 nm changes by less than or equal to 15% when exposed to one or more environmental stressors, in some non-limiting embodiments the percent transmission at wavelengths between 400 nm and 1000 nm of the optical thin film at 550 nm changes by less than or equal to 10% when exposed to one or more environmental stressors, in some non-limiting embodiments the percent transmission at wavelengths between 400 nm and 1000 nm of the optical thin film at 550 nm changes by less than or equal to 5% when exposed to one or more environmental stressors, in some non-limiting embodiments the percent transmission at wavelengths between 400 nm and 1000 nm of the optical thin film at 550 nm changes by less than or equal to 4% when exposed to one or more environmental stressors, in some non-limiting embodiments the percent transmission at wavelengths between 400 nm and 1000 nm of the optical thin film at 550 nm changes by less than or equal to 3% when exposed to one or more environmental stressors, in some non-limiting embodiments the percent transmission at wavelengths between 400 nm and 1000 nm of the optical thin film at 550 nm changes by less than or equal to 2% when exposed to one or more environmental stressors, and in some non-limiting embodiments the percent transmission at wavelengths between 400 nm and 1000 nm of the optical thin film at 550 nm changes by less than or equal to 1% when exposed to one or more environmental stressors.

The optical thin films disclosed herein exhibit excellent reliability-in-use when exposed and / or repeatedly exposed to high temperatures. In some non-limiting embodiments of the optical thin films disclosed herein, the percent transmission at wavelengths between 400 nm and 1000 nm of the optical thin film at 550 nm changes by less than or equal to 20% when exposed to thermal stress of 260 °C for 5 minutes. This test can be repeated, totaling 3 tests, and less than 15% change in transmittance is observed.

The optical thin films disclosed herein exhibit excellent reliability-in-use when exposed and / or repeatedly exposed to high-temperature / high-humidity conditions. In some non-limiting embodiments of the optical thin films disclosed herein, the percent transmission at wavelengths between 400 nm and 1000 nm of the optical thin film at 550 nm changes by less than or equal to 15% when exposed for periods less than or equal to 21 days to thermal and moisture stress in a chamber with 85% relative humidity, heated to 85 °C or in a chamber with 65% relative humidity, heated to 95 °C.

The optical thin films disclosed herein exhibit excellent reliability-in-use when exposed and / or repeatedly exposed to high temperatures for extended periods of time. In some non-limiting embodiments of the optical thin films disclosed herein, the percent transmission at wavelengths between 400 nm and 1000 nm of the optical thin film at 550 nm changes by less than or equal to 15% when exposed for periods less than or equal to 21 days to thermal stress in a chamber heated to 180 °C.

The optical thin films disclosed herein exhibit excellent reliability-in-use when exposed and / or repeatedly exposed to UV light. In some non-limiting embodiments of the optical thin films disclosed herein, the percent transmission at wavelengths between 400 nm and 1000 nm of the optical thin film at 550 nm changes by less than or equal to 15% when exposed to the full solar spectrum to a dose less than or equal to 2 MLux·hr. In some non-limiting embodiments of the optical thin films disclosed herein, the percent transmission at wavelengths between 400 nm and 1000 nm of the optical thin film at 550 nm changes by less than or equal to 30% when exposed to the full solar spectrum to a dose less than or equal to 5 MLux hr.

The present disclosure is further directed to an optical device comprising an optical thin film comprising a copolymer comprising one or more high refractive index first monomers and one or more second monomers comprising a reactive side chain wherein the optical device is a display device. Non-limiting examples of display devices include standard LEDs, mini LEDs, microLEDs, nanoLEDs, QD-LEDs, OLEDS, QD-OLEDs, optical waveguides, CMOS image sensors and others generally known to those having skill in the art. Specific embodiments of these display devices are

generally known to those having skill in the particular art in which they are applied.

Electronic devices that may benefit from having one or more layers comprising the optical materials disclosed herein include, but are not limited to, (1) devices that convert electrical energy into radiation (e.g., a light-emitting diode, light emitting diode display, diode laser, or lighting panel), (2) devices that detect a signal using an electronic process (e.g., a photodiode, a photodetector, a photoconductive cell, a photoresistor, a photoswitch, a phototransistor, a phototube, an infrared ("IR") detector, or a biosensor), (3) devices that convert radiation into electrical energy (e.g., a photovoltaic device or solar cell), (4) devices that convert light of one wavelength to light of a longer wavelength, (e.g., a down-converting phosphor device), (5) devices that include one or more electronic components that include one or more organic semiconductor layers (e.g., a transistor or diode), (6) devices that collect or focus incident light in optical devices (e.g. a microlens in a CMOS image sensor), or any combination of devices in items (1) through (6). In some non-limiting examples, the devices are display devices.

In these electronic devices, the optical materials disclosed herein can be utilized in several different forms, including but not limited to thin films, thick films, and individual optical features of a form to perform the necessary aforementioned functions. Moreover, these films can be modified to include complex topography necessary to perform the necessary aforementioned functions.

This layer structure, and the mismatch of refractive indices between adjacent layers, can greatly reduce the overall efficiency of these devices. Light generated in the emissive layer is lost via scattering and internal reflection. Another potential issue is cross-talk between pixels in OLEDS can lead to efficiency losses that result from unwanted communication between red, green, and blue pixels. The coatings and optical thin films disclosed herein can be used to dampen the refractive index gradient through a device. In some non-limiting embodiments, the coatings and optical thin films disclosed herein can be used as relatively-high-refractive index light-extraction layer between an OLED encapsulant layer and polarizer layer to greatly increase number of photons emitted from a top-display device. In some non-limiting embodiments, the coatings and optical thin films disclosed herein can be used in the formation of relatively low-refractive-index banks between pixels in the emissive layer of an OLED to significantly reduce cross-talk and generate improved efficiencies. Importantly, the refractive indices of the coatings and optical thin films can be tuned via curing processes within a particular composition to accommodate the material changes made elsewhere in the device stack as optimum performance is sought.

In some embodiments, the device is a CMOS image sensor. In these cases, the sensor is comprised of the optical material along with several additional functional layers that serve to guide filtered ambient light to the surface of a single CMOS photodetector, generating an electrical response to a photonic stimulus that can be electronically amplified and processed to create digital information. Most frequently, these functional material layers are patterned and disposed to create an array of many individual wavelength-sensitive photodetectors, frequently called active pixel sensors. By combining and processing active pixel sensor signal information from the multitude of active pixel sensors in the array, a digital image is created.

In this application, the optical material can serve as a simple lens element, focusing ambient light upon an individual active pixel sensor. When functioning as a lens element, the optical material is typically disposed upon a multilayer photodiode component.

The top-most layer of the photodiode component is commonly a pixelated color filter grid composed of optical polymeric materials. The pixelated grid includes several polymer or composite material components that define each pixel area and restrict the transmittance of light through a pixel to a narrow band of wavelengths, commonly referred to as color filter materials. The pixels formed by the color filter materials may also be separated by an additional material component with different optical properties than the color filter materials, alternately referred to as a pixel-defining element, or a spacer element.

In some embodiments of the CMOS image sensor design, referred to as back-side illuminated sensors, beneath the color filter grid layer of the CMOS image sensor is a photodiode comprised of a doped inorganic substrate, such as silicon, serving as the opto-electronic element that enables conversion of light to an electrical signal. The electrical signal generated in the photodiode is amplified and transmitted through a matrix of connectors and transistors to create processed information, and eventually, the image formed by the ambient light entering the sensor.

In other embodiments of the CMOS image sensor design, referred to as front-side illuminated sensors, beneath the color filter grid layer of the CMOS image sensor is a layer comprised of connectors and transistors that create processed information, and the image formed by the ambient light entering the sensor. In this design, the photodiode component that serves as the opto-electronic element that converts light to an electrical signal is disposed beneath the layer of connectors and transistors.

In still other embodiments of the CMOS image sensor design, the lens element layer is further coated with additional material layers that are also penetrated by light en route to the image sensor. These materials may serve one or more of several functional roles to drive improved sensor performance by adjusting component properties, including but not limited to antireflective properties, mechanical properties, optical properties, surface roughness, thermal stability and photostability.

The focal length ($f$) of the lens element comprised of the optical material can vary depending on the refractive index (n) of the optical material and the design of the CMOS image sensor device. The device design can influence the thickness of the lens element layer ($d$) and its radii of curvature ($R_1$, $R_2$), guaranteeing that the majority of light captured by the lens component is delivered to a specific location on the photodiode component. The relationship between these design and performance elements is generally expressed in the lensmaker's equation:

$$\frac{1}{f} = (n-1)\left[\frac{1}{R_1} - \frac{1}{R_2} + \frac{(n-1)d}{nR_1R_2}\right]$$

The device layers can be formed by any deposition technique, or combinations of techniques, including vapor deposition, liquid deposition, and thermal transfer.

In some embodiments of the CMOS image sensor, the optical material comprising the lens element layer must be deposited first into a planar film layer, and then further processed to form the lens in accordance with the device design. The manner of forming the lens shape can vary. In some cases, the lens is formed by lithographic patterning and selective removal of a photoactive optical material comprising the lens, followed by thermal processing above the material's glass transition temperature to reflow the material into a hemispherical shape. In other cases, the lens is formed by coating the optical material comprising the lens with a photoresist that is coated, patterned, and reflowed as described previously, forming a hemispherical lens shape comprised of photoresist resting atop the optical material comprising the lens. In a second step of this process, the lens shape is transferred to the optical material comprising the lens by exposing the film to a reactive ion etch of fluoride or oxygen, among others, leaving behind a lens shape in the optical material comprising the lens. In still other cases, a photoactive optical material comprising the lens is patterned in a low-contrast process using a greyscale photomask, which leaves a lens shape after the exposed portion of the material is removed during a developer step. In other cases, the lens shape is formed through direct contact pattern transfer methods, such as nanoimprinting.

The coatings and optical thin films, and their associated properties, according to the present disclosure may be prepared and used according to the examples set out below. The examples are presented herein for purposes of illustration of the present disclosure and are not intended to limit the scope of the invention described in the claims.

## EXAMPLES

### Copolymer 5 (CP5) synthesis:

To a reactor vessel, cyclopentanone solvent was added. In a separate vessel, V65 radical initiator was added and dissolved in cyclopentanone at room temperature. In a third vessel, 9-vinyl carbazole (VK) monomer was added and dissolved in cyclopentanone at room temperature. 2-(hydroxyethyl) methacrylate (HEMA) monomer was added to this mixture. The contents of the reactor vessel were heated to 80 °C under a nitrogen atmosphere. To this reactor, the contents of the second vessel, containing a solution of V65 initiator in cyclopentanone, were added at a defined rate by syringe pump. Simultaneously, the contents of the third vessel, containing a solution of VK and HEMA monomers in cyclopentanone, were added to the heated reactor by syringe pump. The heated mixture was allowed to stir for a total of 3 hours, and then cooled to room temperature, furnishing a polymer solution of poly(vinylcarbazole-co-(hydroxyethyl)methacrylate). Molecular weight was measured by GPC (Mw = 5700 Da, Mn = 2350 Da). The procedure described above can be used to make a number of related materials described in Table 1.

Table 1.

| Polymer # | Monomer A | Mol% A | Monomer B | Mol% B | **Solvent** |
|---|---|---|---|---|---|
| CP1 | VK | 90 | tBA | 10 | Cyclopentanone |
| CP2 | VK | 80 | PhOBCB | 20 | Cyclopentanone |
| CP3 | VK | 90 | PhOBCB | 10 | Cyclopentanone |
| CP4 | VK | 91 | HEMA | 9 | Cyclopentanone |
| CP5 | VK | 75 | HEMA | 25 | Cyclopentanone |
| CP6 | VK | 90 | HEA | 10 | Cyclopentanone |
| CP7 | VK | 100 | — | — | Cyclopentanone |
| CP8 | VK | 75 | 2-AES | 25 | Cyclopentanone |
| CP9 | VK | 65 | 2-AES | 35 | Cyclopentanone |

(continued)

| Polymer # | Monomer A | Mol% A | Monomer B | Mol% B | **Solvent** |
|---|---|---|---|---|---|
| CP10 | VK | 65 | AA | 35 | Cyclopentanone |
| CP11 | VK | 50 | 2-CEA | 50 | Cyclopentanone |
| CP12 | VK | 70 | HS | 30 | Cyclopentanone |

Note: tBA = *tert*-butylacrylate; PhOBCB = 7-(4-vinylphenoxy)bicyclo[4.2.0]octa-1(6),2,4-triene; HEA = 2-hydroxyethyl acrylate; 2-AES = mono(2-acryloyloxyethyl) succinate; AA = acrylic acid; 2-CEA = 2-carboxyethyl acrylate; HS = 4-hydroxystyrene. CP7 was purchased from Sigma-Aldrich.

Formulation of F1

To a vial, tBA/VK copolymer or copolymer solution in cyclopentanone was added. To this, cyclopentanone solvent, HP-4032, CXC-1821 catalyst, and Polyfox-656 solution in cyclopentanone were added. Components such as antioxidants, radical scavengers, and UV blockers may also be added. The formulation was mixed by using a dispersion device such as a roller or orbital shaker at room temperature. Following mixing, the composition may be filtered using a membrane filter. Other formulations were made with the following compositions.

Table 2.

| Formu-lation # | Polymer # | Polymer wt% | Crosslinker Component | Crosslinker wt% | Catalyst Component | Catalyst wt% | Solvent Component | Solvent wt% | Additives | Additives wt% | SLA | SLA wt% |
|---|---|---|---|---|---|---|---|---|---|---|---|---|
| F1 | CP1 | 28.8% | HP-4032 | 5.4% | CXC-1821 | 1.80% | Cyclopentanone | 64.0% | — | 0% | Polyfox-656 | 0.05% |
| F2 | CP1 | 28.8% | HP-4032 | 5.4% | PTSA-TMP | 1.80% | Cyclopentanone | 64.0% | — | 0% | Polyfox-656 | 0.05% |
| F3 | CP1 | 30.6% | Desmodur BL 3475 | 5.4% | — | 0.00% | Cyclopentanone | 64.0% | — | 0% | | |
| F4 | CP2 | 36.0% | — | 0% | — | 0.00% | Cyclopentanone | 64.0% | — | 0% | Polyfox-656 | 0.05% |
| F5 | CP2 | 35.5% | — | 0% | — | 0.00% | Cyclopentanone | 64.0% | 3,3,5-trimethylcylohexyl salicylate | 0.50% | Polyfox-656 | 0.05% |
| F6 | CP3 | 36.0% | — | 0% | — | 0.00% | Cyclopentanone | 64.0% | — | 0% | Polyfox-656 | 0.05% |
| F7 | CP4 | 33.8% | Hexa(methoxymethyl) melamine | 2.2% | PTSA-TMP | 0.09% | Cyclopentanone | 64.0% | — | 0% | Polyfox-656 | 0.05% |
| F8 | CP4 | 34.5% | Hexa(methoxymethyl) melamine | 1.4% | PTSA-TMP | 0.01% | Cyclopentanone | 64.0% | — | 0% | Polyfox-656 | 0.05% |
| F9 | CP4 | 33.3% | Hexa(methoxymethyl) melamine | 2.2% | PTSA-TMP | 0.09% | Cyclopentanone | 64.0% | tris(trimethylsilyl)silane | 0.18% | Polyfox-656 | 0.05% |
| F10 | CP4 | 33.8% | Hexa(methoxymethyl) melamine | 1.8% | PTSA-TMP | 0.02% | Cyclopentanone | 64.0% | Tinuvin 1600, Tinuvin123 (1:1 wt:wt) | 0.36% | Polyfox-656 | 0.05% |
| F11 | CP4 | 27.3% | 4,4′-[1-[4-[1-[4-Hydroxy-3,5-bis(methoxymethyl) phenyl]-1-methylethyl]phenyl] ethylidene]bis[2,6-bis(methoxymethyl)phenol | 8.3% | PTSA-TMP | 0.36% | Cyclopentanone | 64.0% | — | 0% | Polyfox-656 | 0.05% |
| F12 | CP4 | 33.9% | 1,3,4,6-Tetrakis(methoxymethyl) glycoluril | 2.1% | PTSA-TMP | 0.02% | Cyclopentanone | 64.0% | — | 0% | Polyfox-656 | 0.05% |
| F13 | CP4 | 31.5% | Hexa(methoxymethyl) melamine | 1.4% | PTSA-TMP | 0.01% | Cyclopentanone | 64.0% | gamma-butyrolactone | 3% | Polyfox-656 | 0.05% |
| F14 | CP4 | 31.5% | Hexa(methoxymethyl) melamine | 1.4% | PTSA-TMP | 0.01% | Cyclopentanone | 100.0% | benzyl benzoate | 3% | Polyfox-656 | 0.05% |
| F15 | CP5 | 22.0% | Hexa(methoxymethyl) melamine | 9.0% | PTSA-TMP | 5.00% | Cyclopentanone | 64.0% | — | 0% | Polyfox-656 | 0.05% |
| F16 | CP5 | 26.0% | Hexa(methoxymethyl) melamine | 9.0% | PTSA-TMP | 1.00% | Cyclopentanone | 64.0% | — | 0% | Polyfox-656 | 0.05% |
| F17 | CP6 | 33.8% | Hexa(methoxymethyl) melamine | 2.2% | PTSA-TMP | 0.09% | Cyclopentanone | 64.0% | — | 0% | Polyfox-656 | 0.05% |
| F18 | CP7 | 36.0% | — | 0% | — | 0.00% | Cyclopentanone | 64.0% | — | 0% | Polyfox-656 | 0.05% |

Coating of Formulation F1 to create Film FL1

Approximately 0.3 g of a mixed and filtered composition was deposited onto each of a silicon wafer coupon or an Eagle XG glass coupon (Silicon Valley Microelectronics) (~1"×1") via pipette. The substrate was spun at 1500 rpm for 30 sec to form a film with a thickness of approximately 1 μm. This film was prebaked on a hotplate at 100 °C for 1 min, before an additional bake on a separate hotplate at 200 °C for 5 min.

Film thickness and refractive index measurement of Film FL1

A coated and cured film on silicon was placed on an alpha-SE ellipsometer (J.A. Woollam) for film thickness and refractive index measurement. A Cauchy film model was used to fit: refractive index, attenuation coefficient, surface roughness, native silica thickness, angle offset, and film thickness. Coated and cured films on Eagle XG glass were measured using a Filmetrics thickness measurement instrument.

Film transmittance measurement of Film FL1

A coated and cured film on Eagle XG glass of approximately 2 μm thickness was measured via transmission UV-Vis. An uncoated Eagle XG coupon of the same thickness as the sample substrate was measured as a blank. Three measurements across the sample were then recorded and averaged. A Fourier filter was applied to remove interference fringes from the data, and the data were normalized to a 1.9 μm standard thickness. The %Transmittance was read out from the resulting smoothed and normalized curve.

Table 3.

| **Film #** | **Formulation #** | **Spin speed** | **Spin time** | **Cure temperature** | **Cure time** | **Film thickness** | **RI (@550**nm) | **%T 400nm** (norm. to 1.9 μm) | **%T 650 nm** (norm. to 1.9 μm) |
|---|---|---|---|---|---|---|---|---|---|
| FL1 | F1 | 1500 rpm | 30 sec | 200 °C | 5 min | 2.0 μm | 1.667 | 91.4% | 95.1% |
| FL2 | F2 | 1500 rpm | 30 sec | 200 °C | 5 min | 2.2 μm | - | 92.4% | 96.5% |
| FL3 | F3 | 1500 rpm | 30 sec | 200 °C | 5 min | 3.7 μm | - | 93.3% | 98.1% |
| FL4 | F4 | 1500 rpm | 30 sec | 200 °C | 5 min | 1.8 μm | 1.670 | 95.1% | 97.8% |
| FL5 | F5 | 1500 rpm | 30 sec | 200 °C | 5 min | 1.8 μm | 1.665 | 96.1% | 96.8% |
| FL6 | F6 | 1500 rpm | 30 sec | 200 °C | 5 min | 2.4 μm | - | 98.4% | 97.7% |
| FL7 | F7 | 1500 rpm | 30 sec | 200 °C | 5 min | 2.0 μm | 1.678 | 95.7% | 97.4% |
| FL8 | F8 | 1500 rpm | 30 sec | 200 °C | 5 min | 0.86 μm | 1.675 | 96.9% | 982% |
| FL9 | F9 | 1500 rpm | 30 sec | 200 °C | 5 min | 2.4 μm | 1.679 | 95.9% | 97.9% |
| FL10 | F10 | 1500 rpm | 30 sec | 200 °C | 5 min | 2.2 μm | - | 96.4% | 98.3% |
| FL11 | F11 | 1500 rpm | 30 sec | 200 °C | 5 min | - | 1.664 | - | - |
| FL12 | F12 | 1500 rpm | 30 sec | 200 °C | 5 min | - | - | - | - |
| FL13 | F13 | 1500 rpm | 30 sec | 200 °C | 5 min | - | 1.682 | - | - |
| FL14 | F14 | 1500 rpm | 30 sec | 200 °C | 5 min | 1.9 μm | 1.699 | 96.5% | 98.6% |
| FL15 | F15 | 1500 rpm | 30 sec | 200 °C | 5 min | 1.1 μm | 1.644 | 92.7% | 97.7% |
| FL16 | F16 | 1500 rpm | 30 sec | 200 °C | 5 min | 0.9 μm | 1.654 | 96.9% | 99.8% |
| FL17 | F17 | 1500 rpm | 30 sec | 200 °C | 5 min | - | 1.679 | - | - |
| FL18 | F18 | 1500 rpm | 30 sec | 200 °C | 5 min | 2.02 μm | 1.661 | 96.2% | 97.8% |
| FL19 | F8 | 1500 rpm | 30 sec | 200 °C | 2 min | 0.88 μm | 1.673 | - | - |
| FL20 | F8 | 1500 rpm | 30 sec | 200 °C | 1 min | 0.88 μm | 1.677 | - | - |
| FL21 | F8 | 1500 rpm | 30 sec | 150 °C | 5 min | 0.91 μm | 1.677 | - | - |
| FL22 | F8 | 1500 rpm | 30 sec | 100 °C | 5 min | 0.94 μm | 1.663 | - | - |

Solvent Strip Testing of Film FL1

A coated and cured film on silicon of approximately 1 μm thickness was submerged in a vessel containing gamma butyrolactone (GBL) to completely cover the film. The film was left undisturbed for 10 min. After 10 min, the film was removed with tweezers and dried under a pressurized stream of nitrogen. The film was then further dried on a hotplate at 110 °C for 1 min. The film thicknesses before and after submergence were measured via ellipsometry and compared to determine solvent strip resistance. A passing test was <5% of the film thickness being removed.

Table 4.

| Film # | Formulation # | GBL strip FT | Film thickness change (%ΔFT) | Test outcome |
|---|---|---|---|---|
| FL1 | F1 | 2.0 μm | 3.6% | Pass |
| FL2 | F2 | 1.58 μm | -100.0% | Fail |
| FL4 | F4 | 1.70 μm | -3.8% | Pass |
| FL5 | F5 | 0.40 μm | -1.6% | Pass |
| FL7 | F7 | 0.56 μm | -0.4% | Pass |
| FL8 | F8 | 0.86 μm | -1.7% | Pass |
| FL9 | F9 | 0.59 μm | 0.7% | Pass |
| FL11 | F11 | 0.96 μm | -0.1% | Pass |
| FL12 | F12 | 0.86 μm | -98.6% | Fail |
| FL13 | F13 | 3.78 μm | 0.0% | Pass |
| FL14 | F14 | 3.94 μm | 0.5% | Pass |
| FL15 | F15 | 1.15 μm | 5.1% | Fail |
| FL16 | F16 | 0.97 μm | 34.0% | Fail |
| FL18 | F18 | 3.11 μm | -99.0% | Fail |
| FL19 | F8 | 0.88 μm | -2.1% | Pass |
| FL20 | F8 | 0.88 μm | 0.2% | Pass |
| FL21 | F8 | 0.91 μm | -100.0% | Fail |
| FL22 | F8 | 0.94 μm | -100.0% | Fail |

Formulation of Photopatternable Formulation 1 (PF1)

To a vial, a solution of CP10 2-AES/VK in cyclopentanone was added. To this, PGMEA solvent, CAP-01S copolymer, HR-6042 cross-linkers, SPI-05 catalyst, GSCA-001 adhesion promoter and FZ-2122 surfactant were added. Components such as additional crosslinkers, antioxidants, radical scavengers, and UV blockers may also be added. The formulation was mixed by using a dispersion device such as a roller or orbital shaker at room temperature. Following mixing, the composition may be filtered using a membrane filter. Other formulations were made with the following compositions.

Table 5.

| -lation # | Polymer # | Polymer wt% | Second Polymer Component | Polymer wt% | Crosslinker Component | Crosslinker wt% | Catalyst Component | Catalyst Wt% | Solvent Component | Solvent wt% | Additives | Additives wt% | SLA | SLA wt% |
|---|---|---|---|---|---|---|---|---|---|---|---|---|---|---|
| PF1 | CP8 | 8.22% | CAP-01S | 5.48% | HR-6042 | 5.87 | SPI-05 | 0.82% | PGMEA | 79.51% | GSCA-001 | 0.06% | FZ-2122 | 0.04% |
| PF2 | CP8 | 5.41% | CAP-01S | 8.11% | HR-6042 | 4.83% | SPI-05 | 0.81% | PGMEA | 79.13% | TEPIC-UC | 0.97% | FZ-2122 | 0.04% |
| PF3 | CP9 | 9.77% | CAP-01S | 4.19% | HR-6042 | 4.98% | SPI-05 | 0.83% | PGMEA | 79.13% | GSCA-001<br>TEPIC-UC | 0.06%<br>1.00% | FZ-2122 | 0.04% |
| PF4 | CP8 | 5.19% | CAP-01S | 8.24% | HR-6042 | 4.91% | SPI-05 | 0.82% | PGMEA | 79.79% | GSCA-001<br>TEPIC-UC | 0.06%<br>0.98% | FZ-2122 | 0.04 %<br>0.04% |

Coating film Photopatternable Film Layer 1 (PFL1)

Formulation PF1 was coated onto a bare glass substrate according to the procedure described above to furnish, and prebaked on a hotplate at 105 °C for 90 seconds, leaving film PFL1 at a thickness of approximately 20 micrometers.

Developer solubility test for PFL1

Film PFL1 was placed upon an ADR tool (LuzChem model TFA-11CT). The film was exposed to a 2.38% aqueous tetramethylammonium hydroxide solution for 70 seconds, while the film thickness was optically measured. The film thicknesses before and after exposure were compared to determine film developer solubility.

UV Exposure test for PFL1

After being measured for thickness, film PFL1 was exposed to broadband ultraviolet light to a dosage of 30 $mJ/cm^2$. The film was next exposed to a 2.38% aqueous tetramethylammonium hydroxide solution for 70 seconds, and then rinsed with water and air dried. The film thickness was again measured in the exposed region. The film was baked in a convection oven 230 °C for 30 minutes. The film thicknesses before and after exposure were compared to determine exposed film developer resistance.

Patterning test for PFL1

After being measured for thickness, film PFL1 was placed in a mask aligner (MA6 by Suss). A lithography mask with square patterns with a critical dimension of 50 micrometers was used to selectively expose the film to broadband ultraviolet light to a dosage of 30 $mJ/cm^2$. The film was next exposed to a 2.38% aqueous tetramethylammonium hydroxide solution for 70 seconds, and then rinsed with water. The film was baked in a convection oven at 230 °C for 30 minutes. At various points in the process, the critical dimensions of the patterned features were measured by optical microscopy to give the pattern bias and flow.

Table 6.

| Film # | Source formulation | Refractive Index (@ 550nm) | Soft Baked Developer Exposure Film Thickness Loss (nm) | UV Cured Developer Exposure Film Retention (%) | Patterning Critical Dimension (μm) Bias | Patterning Feature Thermal Flow (μm) |
|---|---|---|---|---|---|---|
| PFL1 | PF1 | 1.647 | Insoluble | Not measured | Not patternable | Not patternable |
| PFL2 | PF2 | 1.628 | 673.6 | 73.8% | 7.60 | 1.2 |
| PFL3 | PF3 | 1.618 | 542.1 | 88.2% | 10.80 | 0.1 |
| PFL4 | PF4 | 1.624 | 540.7 | 77.2% | 7.50 | 1.1 |
| PFL5 | F1 | 1.667 | Insoluble | Not measured | not measured | not measured |

Note that not all of the activities described above in the general description or the examples are required, that a portion of a specific activity may not be required, and that one or more further activities may be performed in addition to those described. Still further, the order in which activities are listed are not necessarily the order in which they are performed.

In the foregoing specification, the concepts have been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of invention.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

It is to be appreciated that certain features are, for clarity, described herein in the context of separate embodiments, may also be provided in combination in a single embodiment. Conversely, various features that are, for brevity,

described in the context of a single embodiment, may also be provided separately or in any subcombination. The use of numerical values in the various ranges specified herein is stated as approximations as though the minimum and maximum values within the stated ranges were both being preceded by the word "about." In this manner, slight variations above and below the stated ranges can be used to achieve substantially the same results as values within the ranges. Also, the disclosure of these ranges is intended as a continuous range including every value between the minimum and maximum average values including fractional values that can result when some of components of one value are mixed with those of different value. Moreover, when broader and narrower ranges are disclosed, it is within the contemplation of this invention to match a minimum value from one range with a maximum value from another range and vice versa.

**Claims**

1. A copolymer composition comprising: (a) one or more high refractive index first monomers comprising an aromatic heterocycle comprising one or more polymerizable functional groups attached to the heteroatom of the aromatic heterocycle ; (b) one or more second monomers comprising a reactive side chain; (c) one or more solvents; and wherein the aromatic heterocycle comprising one or more polymerizable functional groups attached to the heteroatom of the aromatic heterocycle is represented by the following Formula (1):

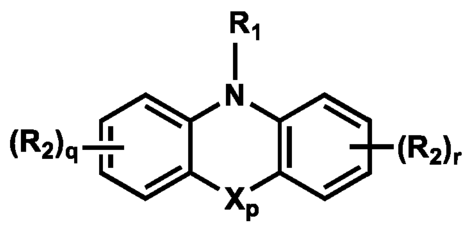

Formula (1)

wherein:

$R_1$ comprises at least one polymerizable functional group selected from the group consisting of a vinyl group, an epoxy group, an oxetanyl group, an acryloyl group, a methacryloyl group, a styrenyl group, a maleate group, and deuterated analogs of these groups;
X is selected from the group consisting of B, N, O, P, Si, and S;
$R_2$ is the same or different at each occurrence and is selected from the group consisting of hydrogen, deuterium, a halogen, hydroxyl, carboxyl, carboxylic acid, ester, acetal, aminal, epoxy, oxetanyl, a cyano, a substituted or unsubstituted $(C_1-C_{30})$alkyl, a substituted or unsubstituted deuterated $(C_1-C_{30})$alkyl, a substituted or unsubstituted $(C_2-C_{30})$alkenyl, a substituted or unsubstituted deuterated $(C_2-C_{30})$alkenyl, a substituted or unsubstituted $(C_2-C_{30})$alkynyl, a substituted or unsubstituted deuterated $(C_2-C_{30})$alkynyl, a substituted or unsubstituted $(C_3-C_{30})$cycloalkyl, a substituted or unsubstituted deuterated $(C_3-C_{30})$cycloalkyl, a substituted or unsubstituted $(C_6-C_{60})$aryl, a substituted or unsubstituted deuterated $(C_6-C_{60})$aryl, a substituted or unsubstituted tri$(C_1-C_{30})$alkylsilyl, a substituted or unsubstituted deuterated tri$(C_1-C_{30})$alkylsilyl, a substituted or unsubstituted tri$(C_6-C_{30})$arylsilyl, a substituted or unsubstituted deuterated tri$(C_6-C_{30})$arylsilyl, a substituted or unsubstituted di$(C_1-C_{30})$alkyl$(C_6-C_{30})$arylsilyl, a substituted or unsubstituted deuterated di$(C_1-C_{30})$alkyl$(C_6-C_{30})$arylsilyl, a substituted or unsubstituted $(C_1-C_{30})$alkyldi$(C_6-C_{30})$arylsilyl, a substituted or unsubstituted deuterated $(C_1-C_{30})$alkyldi$(C_6-C_{30})$arylsilyl, a substituted or unsubstituted mono- or di-$(C_6-C_{30})$arylamino, or a substituted or unsubstituted deuterated mono- or di-$(C_6-C_{30})$arylamino; or may be linked to an adjacent substituent(s) to form a substituted or unsubstituted $(C_3-C_{30})$, mono- or polycyclic, alicyclic or aromatic ring that may or may not contain deuterium, and whose carbon atom(s) may be replaced with at least one hetero atom selected from N, O, and S;
p = 0 or 1; such that when p =0, Formula 1 represents a carbazole; and
q and r are the same or different and are 0, 1, 2, 3, or 4.

2. The copolymer composition of claim 1, wherein the aromatic heterocycle comprising one or more polymerizable functional groups attached to the heteroatom of the aromatic heterocycle is selected from the group consisting of N-vinylcarbazole; N-allylcarbazole; N-glycidyl-carbazole; N-(meth)acryloylcarbazole; carbazoylethyl (meth)acrylate, carbazoylethoxyethyl (meth)acrylate, and carbazoyl (2-methylethyl)(meth)acrylate.

3. The copolymer composition of claim 1, wherein the one or more second monomers comprising a reactive side chain is selected from the group with reactive side chains consisting of hydroxyl, carboxyl, carboxylic acid, ester, acetal, aminal, epoxy, oxetanyl, vinyl, vinyl ether, acryloyl, and methacryloyl.

4. The copolymer composition of claim 3, wherein the one or more second monomers comprising a reactive side chain is selected from the group consisting of acrylic acid, (meth)acrylic acid, methyl (meth)acrylate, ethyl (meth)acrylate, N-propyl (meth)acrylate, isopropyl (meth)acrylate, n-butyl (meth)acrylate, isobutyl (meth)acrylate, t-butyl (meth)acrylate, methyl 2-ethylhexyl (meth)acrylate, glycidyl (meth)acrylate cyclohexyl acrylate, benzyl (meth)acrylate, 2-hydroxyethyl acrylate, 2-hydroxyethyl (meth) acrylate, 2-carboxyethyl acrylate, 2-carboxyethyl methacrylate, mono(2-acryloyloxyethyl)succinate, mono(2-methacryloyloxyethyl)succinate, styrene, hydroxystyrene, styrene-carboxylic acid, vinyltoluene, α-methylstyrene, myrcene, maleimide, N-benzylmaleimide, N-cyclohexylmaleimide, methyl-2,2′-[oxybis (methylene)] bis-2-propenoate, diethyl-2,2′-[oxybis (methylene)] bis-2-propenoate, butadiene, isoprene, ethylene, propylene, vinyl chloride, acrylonitrile, vinyl acetate, vinyl phenoxy benzocyclobutene, and the like and combinations thereof.

5. The copolymer composition of claim 1, wherein the one or more solvents is selected from the group consisting of ethers, ketones, esters, alcohols, and aromatic hydrocarbons.

6. The copolymer composition of claim 1 additionally comprising: (a) one or more additional polymers or copolymers comprising first, second or third monomers or with side chains possessing high optical density, or reactive side chains, or polar protic side chains and the like and combinations thereof; (b) a thermally- or photochemically-activated catalyst; and (c) one or more additional cosolvents.

7. A formulation comprising: (a) the copolymer composition of claim 1; and (b) one or more solvents.

8. The formulation of claim 7 additionally comprising one or more components selected from the group consisting of crosslinkers, thermal acid generators, antioxidants, surfactants, surface leveling agents, photoinitiators, photoacid generators, oxygen scavengers, UV blockers, hindered-amine light stabilizers and one or more cosolvents.

9. An optical thin film comprising a copolymer comprising one or more high refractive index first monomers and one or more second monomers comprising a reactive side chain.

10. An optical device comprising the optical thin film of claim 9 wherein the optical device is a display device.

Europäisches Patentamt
European Patent Office
Office européen des brevets

# EUROPEAN SEARCH REPORT

Application Number
EP 21 20 1223

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2015 0112424 A (DONGWOO FINE CHEM CO LTD [KR]) 7 October 2015 (2015-10-07)<br>* paragraphs [0187], [0189] - [0192], [0221] - [0232] *<br>* examples 1-6; table 1 * | 1-5,7-10 | INV.<br>C08F226/06<br>C08K5/00<br>G03F7/004<br>C08L39/04<br>G02B5/00<br>G02F1/00<br>G03F7/033 |
| X | JP 2003 142272 A (NICHIA KAGAKU KOGYO KK) 16 May 2003 (2003-05-16)<br>* synthesis example 1;<br>paragraph [0001]; example 1 * | 1-5,7-9 | |
| X | HUANG CHENGYU ET AL: "Electrochemical Cross-Linking and Patterning of Nanostructured Polyelectrolyte-Carbazole Precursor Ultrathin Films", MACROMOLECULES, [Online] vol. 41, no. 13, 1 July 2008 (2008-07-01), pages 4661-4670, XP055894207, US<br>ISSN: 0024-9297, DOI: 10.1021/ma800268n<br>Retrieved from the Internet:<br>URL:https://pubs.acs.org/doi/pdf/10.1021/ma800268n><br>[retrieved on 2022-02-22]<br>* abstract *<br>* scheme 1 and experimental section * | 1-5,7,9 | TECHNICAL FIELDS SEARCHED (IPC)<br>C08F<br>C08K<br>G03F<br>G02F<br>G02B |

-/--

4

The present search report has been drawn up for all claims

| Place of search | Date of completion of the search | Examiner |
|---|---|---|
| The Hague | 23 February 2022 | Dessemond, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches Patentamt
European Patent Office
Office européen des brevets

# EUROPEAN SEARCH REPORT

Application Number
EP 21 20 1223

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HUANG JING ET AL: "Green Synthesis of Water-Compatible Fluorescent Molecularly Imprinted Polymeric Nanoparticles for Efficient Detection of Paracetamol", ACS SUSTAINABLE CHEMISTRY & ENGINEERING, [Online] vol. 6, no. 8, 6 August 2018 (2018-08-06), pages 9760-9770, XP055893914, US ISSN: 2168-0485, DOI: 10.1021/acssuschemeng.8b00823 Retrieved from the Internet: URL:https://pubs.acs.org/doi/pdf/10.1021/acssuschemeng.8b00823> [retrieved on 2022-02-22] * abstract * * scheme 1 and experimental section; figure 1 * ----- | 1-4,7,8 | |
| X | VERTSIMAKHA YA ET AL: "Effects of Substituents in Polyvinylcarbazole Structures on Their Optical Properties", JOURNAL OF APPLIED SPECTROSCOPY, NEW YORK,NY, US, [Online] vol. 82, no. 6, 18 January 2016 (2016-01-18), pages 910-914, XP035912708, ISSN: 0021-9037, DOI: 10.1007/S10812-016-0203-7 [retrieved on 2016-01-18] * abstract * * experimental * ----- | 1-3,5,7,9 | TECHNICAL FIELDS SEARCHED (IPC) |
| X | US 2016/200851 A1 (LEE SUNG KYOUNG [KR] ET AL) 14 July 2016 (2016-07-14) * paragraphs [0001], [0023], [0024], [0051], [0056]; examples 1-6 * ----- | 1-5,9,10 | |

-/--

4 The present search report has been drawn up for all claims

| Place of search | Date of completion of the search | Examiner |
|---|---|---|
| The Hague | 23 February 2022 | Dessemond, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 21 20 1223

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2012 078501 A (FUJIFILM CORP) 19 April 2012 (2012-04-19) * paragraphs [0001], [0079] - [0081], [0106] - [0126] * * synthesis examples 1-5; examples 1,2,6,7,917; table 3 * * examples 18, 19, 26, 27; table 5 * ----- | 1-10 | |

TECHNICAL FIELDS SEARCHED (IPC)

4

The present search report has been drawn up for all claims

| Place of search | Date of completion of the search | Examiner |
|---|---|---|
| The Hague | 23 February 2022 | Dessemond, C |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 3 of 3

## ANNEX TO THE EUROPEAN SEARCH REPORT ON EUROPEAN PATENT APPLICATION NO. EP 21 20 1223

This annex lists the patent family members relating to the patent documents cited in the above-mentioned European search report. The members are as contained in the European Patent Office EDP file on
The European Patent Office is in no way liable for these particulars which are merely given for the purpose of information.

23-02-2022

| Patent document cited in search report | Publication date | Patent family member(s) | Publication date |
|---|---|---|---|
| KR 20150112424 A | 07-10-2015 | NONE | |
| JP 2003142272 A | 16-05-2003 | NONE | |
| US 2016200851 A1 | 14-07-2016 | CN 105473647 A | 06-04-2016 |
| | | JP 6143961 B2 | 07-06-2017 |
| | | JP 2016528349 A | 15-09-2016 |
| | | KR 20150021006 A | 27-02-2015 |
| | | US 2016200851 A1 | 14-07-2016 |
| JP 2012078501 A | 19-04-2012 | JP 2012078501 A | 19-04-2012 |
| | | KR 20130124497 A | 14-11-2013 |
| | | WO 2012043719 A1 | 05-04-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20140120469 A1
- US 8431325 B, Hashimoto
- US 4189323 A


### Non-patent literature cited in the description


- *Thin Solid Films,* 2015, vol. 597, 212-219